# EUROPEAN PATENT APPLICATION

(11) **EP 4 582 898 A1**
(43) Date of publication of application: **09.07.2025**
(21) Application number: 23860651.1
(22) Date of filing: 06.07.2023
(51) Int. Cl.: G06F 1/16, F16C 11/04

(54) **HINGE STRUCTURE AND ELECTRONIC DEVICE COMPRISING SAME**

(30) Priority: 02.09.2022 KR 20220111164; 07.10.2022 KR 20220129063
(71) Applicant: Samsung Electronics Co., Ltd., Suwon-si, Gyeonggi-do 16677 (KR)
(72) Inventor: HEO, Jeonhoe, Suwon-si Gyeonggi-do 16677 (KR); CHOI, Hyunsuk, Suwon-si Gyeonggi-do 16677 (KR); LEE, Minseok, Suwon-si Gyeonggi-do 16677 (KR); LEE, Jeongmi, Suwon-si Gyeonggi-do 16677 (KR); HONG, Jaeseung, Suwon-si Gyeonggi-do 16677 (KR)
(74) Representative: Gulde & Partner
(86) International application number: PCT/KR2023/009554
(87) International publication number: WO 2024/048968

(57) **Abstract**

According to an embodiment of the present disclosure, the electronic device may comprise a first housing, a second housing, at least one hinge structure, and a flexible display. The at least one hinge structure may rotatably connect the first housing and the second housing. The at least one hinge structure may include a first rotation cam member, a second rotation cam member, and at least one hinge bracket. The first rotation cam member may include a first rotation shaft or a plurality of first magnetic members. The second rotation cam member may include a second rotation shaft or a plurality of second magnetic members. The at least one hinge bracket may rotatably support the first rotation shaft and the second rotation shaft.

## Description

### [Technical Field]

Various embodiments of the disclosure relate to an electronic device, e.g., a hinge structure and an electronic device including the same.

### [Background Art]

Advancing information communication technologies and semiconductor technologies accelerate the spread and use of various electronic devices. In particular, recent electronic devices are being developed to carry out communication while carried on.

The term "electronic device" may mean a device performing a particular function according to its equipped program, such as a home appliance, an electronic scheduler, a portable multimedia player, a mobile communication terminal, a tablet PC, a video/sound device, a desktop PC or laptop computer, a navigation for automobile, etc. For example, the electronic devices may output stored information as voices or images. As electronic devices are highly integrated, and high-speed, high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as replaying music/videos, a communication and security function for mobile banking, and a scheduling or e-wallet function. These electronic devices have been downsized to be conveniently carried by users.

As mobile communication services extend up to multimedia service sectors, the display of the electronic device may be increased to allow the user satisfactory use of multimedia services as well as voice call or text messaging services. Accordingly, a foldable flexible display may be disposed on the entire area of the housing structure separated to be foldable.

### [Detailed Description of the Invention]

### [Technical Solution]

According to an embodiment of the disclosure, an electronic device may comprise a first housing, a second housing, at least one hinge structure, or a flexible display. The second housing may be configured to be rotated relative to the first housing. The at least one hinge structure may be disposed between the first housing and the second housing. The at least one hinge structure may rotatably connect the first housing and the second housing. The flexible display may be disposed between the first housing and the second housing. The at least one hinge structure may include a first rotation cam member, a second rotation cam member, and at least one hinge bracket. The first rotation cam member may be coupled to the first housing. The first rotation cam member may include a first rotation shaft or a plurality of first magnetic members. The plurality of first magnetic members may be disposed adjacent to the first rotation shaft. The second rotation cam member may be coupled to the second housing. The second rotation cam member may include a second rotation shaft or a plurality of second magnetic members. The plurality of second magnetic members may be disposed adjacent to the second rotation shaft. The at least one hinge bracket may rotatably support the first rotation shaft and the second rotation shaft. The at least one hinge bracket may include at least one facing portion. The at least one facing portion may face the plurality of first magnetic members and the plurality of second magnetic members.

According to an embodiment of the disclosure, an electronic device may comprise a first housing, a second housing, at least one hinge structure, or a flexible display. The second housing may be configured to be rotated relative to the first housing. The at least one hinge structure may be disposed between the first housing and the second housing. The at least one hinge structure may rotatably connect the first housing and the second housing. The flexible display may be disposed between the first housing and the second housing. The at least one hinge structure may include a hinge plate, a 1-1th rotation cam member, a 1-2th rotation cam member, and a first hinge bracket. The 1-1th rotation cam member may be coupled to the first housing. The 1-1th rotation cam member may include a 1-1th rotation shaft or a plurality of 1-1th magnetic members. The plurality of 1-1th magnetic members may be disposed adjacent to the 1-1th rotation shaft. The 1-2th rotation cam member may be coupled to the second housing. The 1-2th rotation cam member may include a 1-2th rotation shaft or a plurality of 1-2th magnetic members. The plurality of 1-2th magnetic members may be disposed adjacent to the 1-2th rotation shaft. The first hinge bracket may be slidably coupled to the hinge plate. The first hinge bracket may include at least one first guide portion or at least one first facing portion. The at least one first guide portion may rotatably support the 1-1th rotation shaft and the 1-2th rotation shaft. The at least one first facing portion may face the plurality of 1-1th magnetic members and the plurality of 1-2th magnetic members.

### [Brief Description of the Drawings]

FIG. 1 is a block diagram illustrating an electronic device in a network environment according to an embodiment;
FIG. 2 is a view illustrating an unfolded state of an electronic device according to an embodiment of the disclosure;
FIG. 3 is a view illustrating a folded state of an electronic device according to an embodiment of the disclosure;
FIG. 4 is an exploded perspective view illustrating an electronic device according to an embodiment of the disclosure;
FIG. 5 is a view illustrating an electronic device and hinge modules according to an embodiment of the disclosure;
FIG. 6A is a perspective view illustrating a coupled hinge module according to an embodiment of the disclosure;
FIGS. 6B, 6C, and 6D are exploded perspective views illustrating a hinge module according to an embodiment of the disclosure;
FIG. 7A is a perspective view illustrating a portion of a 2-1th rotation cam member according to an embodiment of the disclosure;
FIG. 7B is a perspective view illustrating a second hinge bracket according to an embodiment of the disclosure;
FIG. 8A is a perspective view illustrating a state in which a first hinge bracket and at least one first rotation cam member are disposed in a first state according to an embodiment of the disclosure;
FIG. 8B is a perspective view illustrating a state in which a first hinge bracket and at least one first rotation cam member are disposed in a second state according to an embodiment of the disclosure;
FIG. 9 is a cross-sectional view illustrating an electronic device according to an embodiment of the disclosure;
FIGS. 10A, 10B, 10C, 10D, and 10E are views illustrating a hinge structure according to an embodiment of the disclosure;
FIG. 11 is a view schematically illustrating an attaching force by magnetism according to an embodiment of the disclosure;
FIG. 12A is a view illustrating a first facing portion of a first hinge bracket according to an embodiment of the disclosure;
FIG. 12B is a view illustrating 1-1th magnetic members of a 1-1th rotation cam member according to an embodiment of the disclosure;
FIG. 13 is a view illustrating an attaching force by magnetism according to an embodiment of the disclosure;
FIG. 14A is a view illustrating a first facing portion of a first hinge bracket according to an embodiment of the disclosure;
FIG. 14B is a view illustrating 1-1th magnetic members of a 1-1th rotation cam member according to an embodiment of the disclosure;
FIG. 15 is a view illustrating an attaching force by magnetism according to an embodiment of the disclosure;
FIG. 16A is a view illustrating a first facing portion of a first hinge bracket according to an embodiment of the disclosure;
FIG. 16B is a view illustrating 1-1th magnetic members of a 1-1th rotation cam member according to an embodiment of the disclosure;
FIG. 17 is a view illustrating an attaching force by magnetism according to an embodiment of the disclosure;
FIG. 18 is a perspective view illustrating a portion of a 2-1th rotation cam member according to an embodiment of the disclosure;
FIG. 19A is a view illustrating a first facing portion of a first hinge bracket according to an embodiment of the disclosure;
FIG. 19B is a view illustrating 1-1th magnetic members of a 1-1th rotation cam member, arranged in a Halbach array, according to an embodiment of the disclosure;
FIG. 20 is a view illustrating an attaching force by magnetism according to an embodiment of the disclosure;
FIG. 21A is a view illustrating a first facing portion of a first hinge bracket according to an embodiment of the disclosure;
FIG. 21B is a view illustrating 1-1th magnetic members of a 1-1th rotation cam member, arranged in a Halbach array, according to an embodiment of the disclosure; and
FIG. 22 is a view illustrating an attaching force by magnetism according to an embodiment of the disclosure.

### [Mode for Carrying out the Invention]

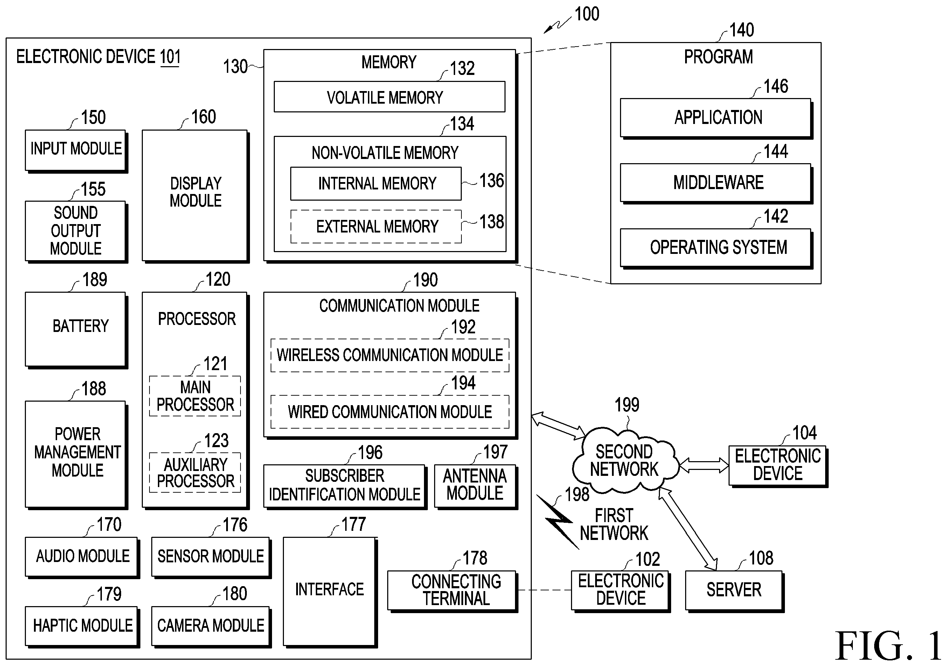

FIG. 1 is a block diagram illustrating an electronic device 101 in a network environment 100 according to various embodiments.

Referring to FIG. 1, the electronic device 101 in the network environment 100 may communicate with at least one of an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. According to an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include one antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or clientserver computing technology may be used, for example. The electronic device 101 may provide ultra low-latency services using, e.g., distributed computing or mobile edge computing. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities. Some of the plurality of entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

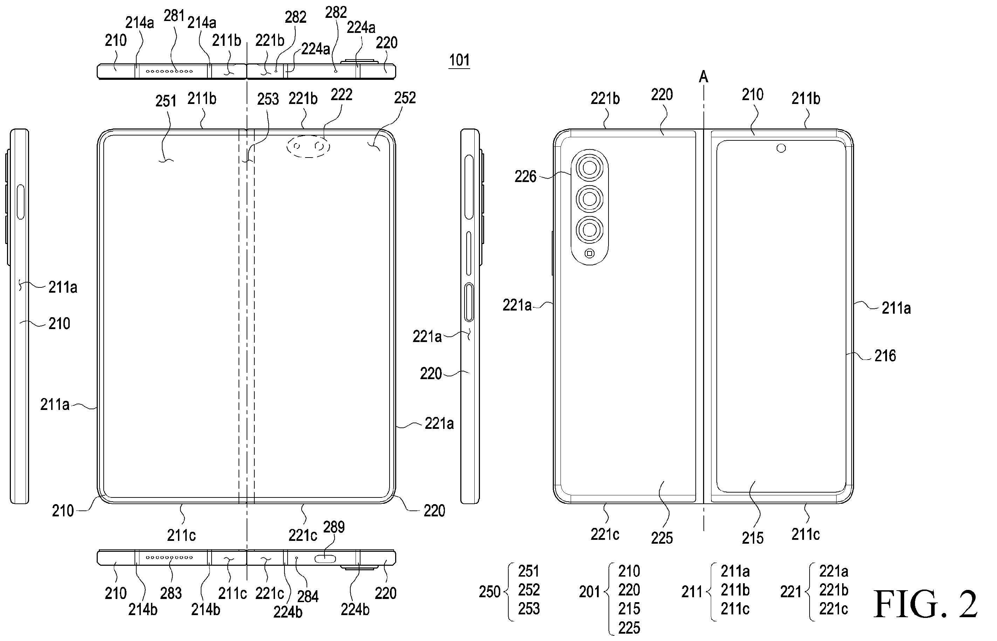

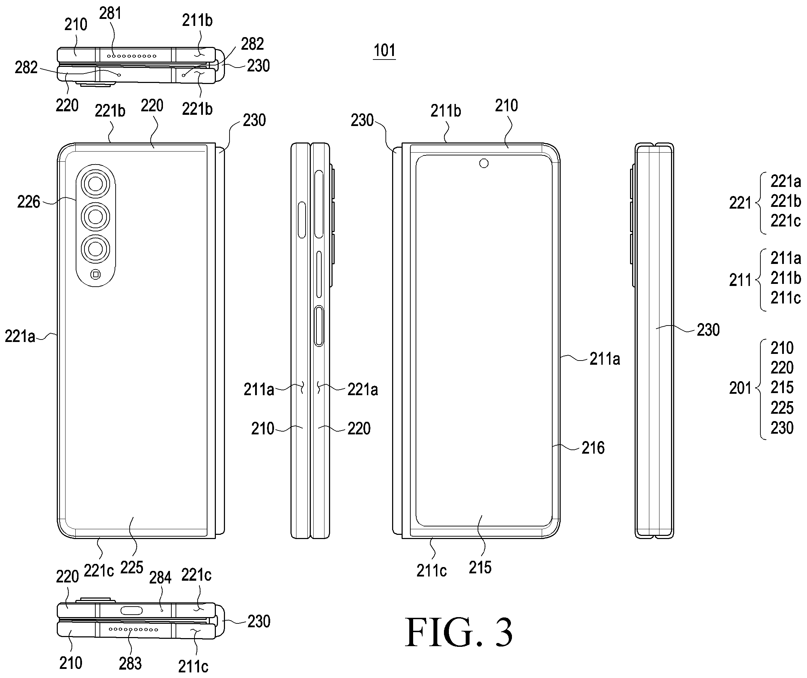

FIG. 2 is a view illustrating an unfolded state of an electronic device according to an embodiment of the disclosure. FIG. 3 is a view illustrating a folded state of an electronic device according to an embodiment of the disclosure.

FIG. 2 is a view illustrating an unfolded status among folded statuses of an electronic device (or a foldable electronic device) according to an embodiment of the disclosure. FIG. 3 is a view illustrating a folded status of the electronic device (or a foldable electronic device) according to an embodiment of the disclosure. The electronic device 101 of FIGS. 2 and 3, as an example of the electronic device 101 shown in FIG. 1, may be a foldable or bendable electronic device.

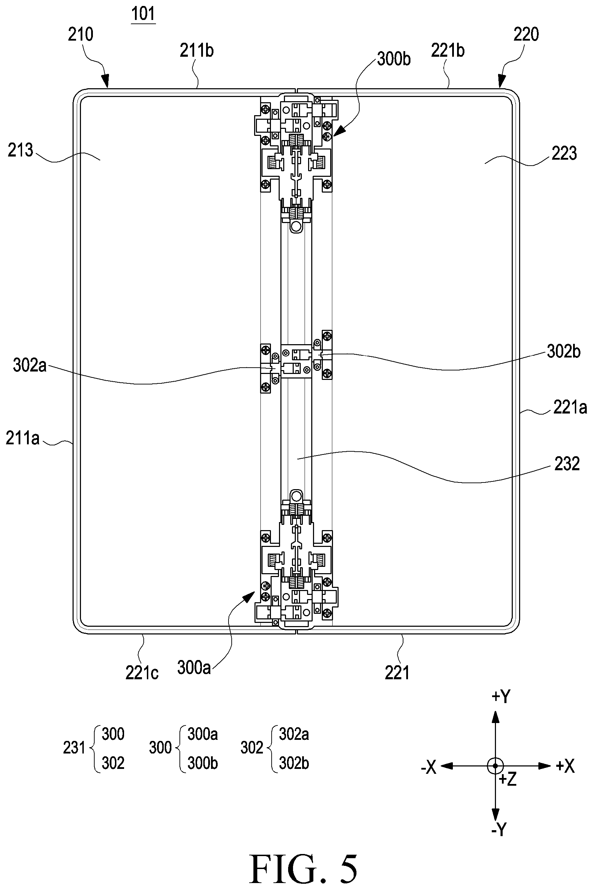

The embodiments of FIGS. 2 and 3 may be combined with the embodiment of FIG. 1 or the embodiments of FIGS. 5 to 11B.

The configuration of the electronic device 101 of FIGS. 2 and 3 may be identical in whole or part to the configuration of the electronic device 101 of FIG. 1.

Referring to FIGS. 2 and 3, according to an embodiment, an electronic device 101 may include a foldable housing 201 and a flexible or foldable display 250 (hereinafter, simply " flexible display 250") (e.g., the display module 160 of FIG. 1) disposed in a space formed by the foldable housing 201. According to an embodiment, the surface where the flexible display 250 is disposed (or the surface where the flexible display 250 is viewed from the outside of the electronic device 101) may be defined as the front surface of the electronic device 101. The opposite surface of the front surface may be defined as a rear surface of the electronic device 101. The surface surrounding the space between the front and back surfaces may be defined as a side surface of the electronic device 101.

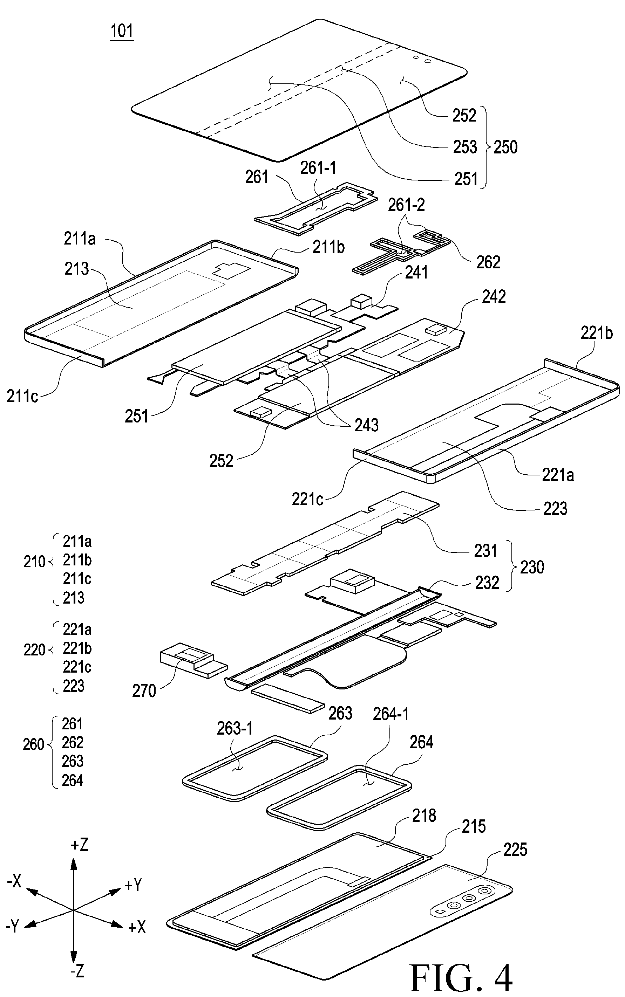

According to an embodiment, the foldable housing 201 may include a first housing 210, a second housing 220 including a sensor area 222, a first rear cover 215, a second rear cover 225, and a hinge assembly 230. According to an embodiment, the hinge assembly 230 may include a hinge cover (e.g., the hinge cover 232 of FIG. 4) that covers the foldable portion of the foldable housing 201. The foldable housing 201 of the electronic device 101 are not limited to the shape and coupling shown in FIGS. 2 and 3 but may rather be implemented in other shapes or via a combination and/or coupling of other components. For example, in an embodiment, the first housing 210 and the first rear cover 215 may be integrally formed with each other, and the second housing 220 and the second rear cover 225 may be integrally formed with each other.

According to an embodiment, an illuminance sensor and an image sensor may be disposed in the sensor area 222. The illuminance sensor may detect the amount of light around the electronic device 101. The image sensor may convert the light incident through the camera lens into a digital signal. The illuminance sensor and the image sensor may be visually exposed to the flexible display 250. According to an embodiment, the illuminance sensor and the image sensor may not be visually exposed. For example, the camera may be configured as an under display camera (UDC). Pixels in one area of the flexible display 250 corresponding to the location of the UDC may be configured to differ from pixels in other areas, so that the image sensor and/or camera may not be visually exposed.

According to an embodiment, the first housing 210 may be connected to the hinge assembly 230 and may include a first front surface facing in a first direction and a first rear surface facing in a direction opposite to the first direction. The second housing 220 may be connected to the hinge assembly 230 and may include a second front surface facing in a second direction and a second rear surface facing in a direction opposite to the second direction. The first housing 210 may rotate about the hinge assembly 230 with respect to the second housing 220. The second housing 220 may rotate about the hinge assembly 230 with respect to the first housing 210. The electronic device 101 may transform to a folded status or an unfolded status.

According to an embodiment, the first housing 210 may include a 1-1th side surface 211a disposed to be spaced apart from and in parallel to the folding axis A of the hinge assembly 230 between the first front surface and the first rear surface, and the second housing 220 may include a 2-1th side surface 221a disposed to be spaced apart from and in parallel to the folding axis A of the hinge assembly 230 between the second front surface and the second rear surface. Further, the first housing 210 may include a 1-2th side surface 121b perpendicular to the 1-1th side surface 211a and having an end connected with the 1-1th side surface 211a and another end connected with the hinge assembly 230 and a 1-3th side surface 211c perpendicular to the 1-1th side surface 211a and having an end connected with the 1-1th side surface 211a and another end connected with the hinge assembly 230 and spaced apart from and in parallel to the 1-2th side surface 211b. The second housing 220 may include a 2-2th side surface 221b perpendicular to the 2-1th side surface 221a and having an end connected with the 2-1th side surface 221a and another end connected with the hinge assembly 230 and a 2-3th side surface 221c perpendicular to the 2-1th side surface 221a and having an end connected with the 2-1th side surface 221a and another end connected with the hinge assembly 230 and spaced apart from and in parallel to the 2-2th side surface 221b. When the first housing 210 is folded about the hinge assembly 230 with respect to the second housing 220 (e.g., FIG. 3), the 1-1th side surface 211a may approach the 2-1th side surface 221a and, when the first housing 210 is unfolded about the hinge assembly 230 with respect to the second housing 220 (e.g., FIG. 2), the 1-1th side surface 211a may move away from the 2-1th side surface 221a.

According to an embodiment, in the fully folded state of the electronic device 101, the first front surface may face the second front surface and, in the fully unfolded state, the first direction may be identical to the second direction. In the fully unfolded state, the distance between the 1-1th side surface 211a and the 2-1th side surface 221a may be the largest.

According to an embodiment, the first housing 210 and the second housing 220 are disposed on two opposite sides of the folding axis A and be overall symmetrical in shape with respect to the folding axis A. As described below, the angle or distance between the first housing 210 and the second housing 220 may be varied depending on whether the electronic device 101 is in the unfolded state, the folded state, or the partially unfolded (or partially folded) intermediate state.

According to an embodiment, as shown in FIG. 2, the first housing 210 and the second housing 220 together may form a recess to receive the flexible display 250. According to an embodiment, at least a portion of the first housing 210 and the second housing 220 may be formed of a metallic material or a non-metallic material having rigidity of a selected size for supporting the flexible display 250. At least a portion formed of metal may provide a ground plane of the electronic device 101 and may be electrically connected with a ground line formed on the printed circuit board disposed in the foldable housing 201.

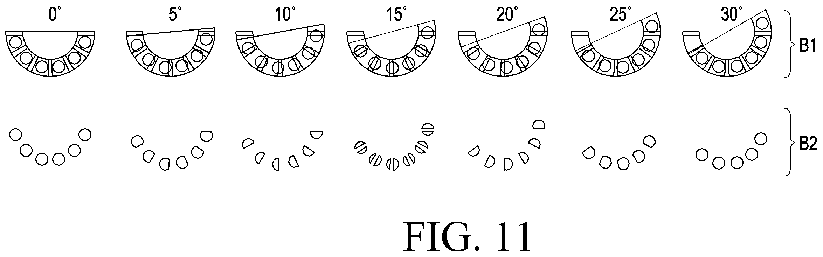

According to an embodiment, a protection member may be disposed outside the flexible display 250. The protection member (e.g., the protection member 219 of FIGS. 11A and 11B) may be formed integrally with, or as a separate structure from, a side surface of the foldable housing 201. The flexible display 250 may not adhere to the side surface of the foldable housing 201 and/or the protection member. A gap may be formed between the flexible display 250 and the protection member. The protection member may be configured to cover the internal configuration of the electronic device 101 from the outside or to protect the internal configuration of the electronic device 101 from external impact. According to an embodiment, the protection member may be configured to cover the line mounted on the flexible display 250 from the outside or to protect it from an external impact.

According to an embodiment, the first rear cover 215 may be disposed on one side of the folding axis A on the rear surface of the electronic device 101 and have, e.g., a substantially rectangular periphery which may be surrounded by the first housing 210. Similarly, the second rear cover 225 may be disposed on the opposite side of the folding axis A on the rear surface of the electronic device 101 and its periphery may be surrounded by the second housing 220.

According to an embodiment, the first rear cover 215 and the second rear cover 225 may be substantially symmetrical in shape with respect to the folding axis A. However, the first rear cover 215 and the second rear cover 225 are not necessarily symmetrical in shape. In another embodiment, the electronic device 101 may include the first rear cover 215 and the second rear cover 225 in various shapes. In another embodiment, the first back cover 215 may be integrally formed with the first housing 210, and the second back cover 225 may be integrally formed with the second housing 220.

According to an embodiment, the first rear cover 215, the second rear cover 225, the first housing 210, and the second housing 220 may form a space where various components (e.g., a printed circuit board or battery) of the electronic device 101 may be disposed. According to an embodiment, one or more components may be disposed or visually exposed on the rear surface of the electronic device 101. For example, at least a portion of a sub display (e.g., the sub display 218 of FIG. 4) may be visually exposed through a first back surface area 216 of the first back cover 215. For example, one or more components or sensors may be visually exposed through a second rear surface area 226 of the second rear cover 225. In an embodiment, the sensor may include a proximity sensor and/or a rear camera.

According to an embodiment, the front camera disposed on the front surface (e.g., the second front surface) of the electronic device 101 or the rear camera exposed through the second rear area 226 of the second rear cover 225 may include one or more lenses, an image sensor, and/or an image signal processor. The flash may include, e.g., a light emitting diode (LED) or a xenon lamp. In an embodiment, two or more lenses (an infrared (IR) camera, a wide-angle lens, and a telescopic lens) and image sensors may be disposed on one surface of the electronic device 101.

Referring to FIG. 3, the hinge cover (e.g., the hinge cover 232 of FIG. 4) included in the hinge assembly 230 may be disposed between the first housing 210 and the second housing 220 to hide the internal components (e.g., the hinge structure 231 of FIG. 4). According to an embodiment, the hinge assembly 230 may be hidden by a portion of the first housing 210 and second housing 220 or be exposed to the outside depending on the state (the unfolded state, intermediate state, or folded state) of the electronic device 101.

According to an embodiment of the present invention, as shown in FIG. 2, in the unfolded state (e.g., a fully unfolded state) of the electronic device 101, the hinge assembly 230 may be hidden not to be exposed by the first housing 210 and the second housing 220. According to an embodiment, as shown in FIG. 3, in the folded state (e.g., a fully folded state) of the electronic device 101, the hinge assembly 230 may be exposed to the outside between the first housing 210 and the second housing 220. As another example, in an intermediate state in which the first housing 210 and the second housing 220 are folded with a certain angle, the hinge assembly 230 may be partially exposed to the outside between the first housing 210 and the second housing 220. However, in this case, the exposed area may be smaller than that in the completely folded state. In an embodiment, the hinge assembly 230 may include a curved surface.

In an embodiment, the flexible display 250 may be disposed in a space formed by the foldable housing 201. For example, the flexible display 250 may be seated in a recess formed by the foldable housing 201 and may be seen from the outside through the front surface (e.g., the first front surface and/or the second front surface) of the electronic device 101. According to an embodiment, the flexible display 250 may constitute most of the front surface (e.g., the first front surface and/or the second front surface) of the electronic device 101. Accordingly, the front surface (e.g., the first front surface and/or the second front surface) of the electronic device 101 may include the flexible display 250 and a partial area of the first housing 210 and a partial area of the second housing 220 adjacent to the flexible display 250. The rear surface (e.g., the first rear surface and/or second rear surface) of the electronic device 101 may include the first rear cover 215, a partial area of the first housing 210 adjacent to the first rear cover 215, the second rear cover 225, and a partial area of the second housing 220 adjacent to the second rear cover 225.

According to an embodiment, the flexible display 250 may refer to a display in which at least a partial area thereof may be deformed into a flat surface or a curved surface. According to an embodiment, the flexible display 250 may include a folding area 253, a first display area 251 disposed on one side of the folding area 253 (e.g., the left side of the folding area 253 of FIG. 2), and a second display area 252 disposed on the opposite side of the folding area 253 (e.g., the right side of the folding area 203 of FIG. 2).

According to an embodiment, the first display area 251 may be disposed on the first housing 210, and the second display area 252 may be disposed on the second housing 220. According to an embodiment, the folding area 253 may connect the first display area 251 and the second display area 252, and may be disposed on the hinge assembly 230.

The segmentation of the flexible display 250 as shown in FIG. 2 is merely an example, and the display 250 may be divided into a plurality of (e.g., four or more, or two) areas depending on the structure or function of the display 200. For example, in the embodiment illustrated in FIG. 2, the area of the flexible display 250 may be divided by the folding area 253 extending parallel to the folding axis A, but the area of the flexible display 250 may be divided by another folding axis (e.g., a folding axis parallel to the width direction of the electronic device).

According to an embodiment, the flexible display 250 may be coupled to or disposed adjacent to a touch panel having a pressure sensor capable of measuring the intensity (pressure) of touch or a touch sensing circuit. For example, the flexible display 250 may be disposed adjacent to or coupled with a touch panel, as an example of the touch pane, which detects a stylus pen of an electromagnetic resonance (EMR) type.

According to an embodiment, the first display area 251 and the second display area 252 may be overall symmetrical in shape with respect to the folding area 253.

Described below are the operation of the first housing 210 and the second housing 220 and each area of the flexible display 250 depending on the state (e.g., the folded state, unfolded state, or intermediate state) of the electronic device 101.

According to an embodiment, when the electronic device 101 is in the unfolded state (e.g., FIG. 2), the first housing 210 and the second housing 220 may be disposed to face in the same direction while forming an angle of 180 degrees. The surface of the first display area 251 and the surface of the second display area 252 of the flexible display 250 may be angled at 180 degrees therebetween while facing in the same direction (e.g., forward of the front surface of the electronic device). In this case, the folding area 253 may form the same plane with the first display area 251 and the second display area 252.

According to an embodiment, when the electronic device 101 is in the folded state (e.g., FIG. 3), the first housing 210 and the second housing 220 may be disposed to face each other. According to an embodiment, the electronic device 101 may include an in-folding type electronic device or an out-folding type electronic device. The in-folding type may mean a state in which the flexible display 250 is not exposed to the outside in the fully folded state. For example, it may mean a state in which the flexible display 250 is folded in the front direction. The out-folding type may mean a state in which the flexible display 250 is visually exposed to the outside in the fully folded state. For example, it may mean a state in which the flexible display 250 is folded in the rear direction.

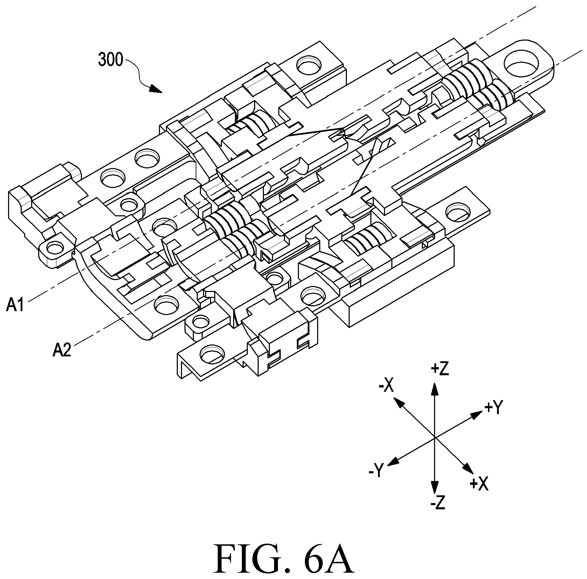

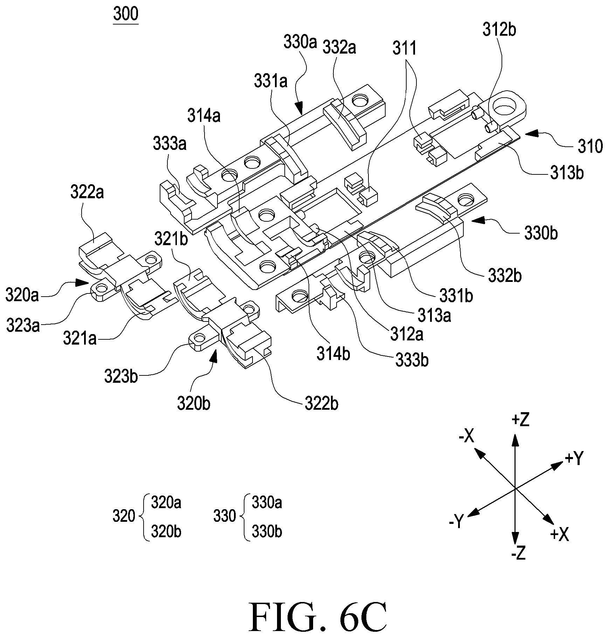

According to an embodiment, when the electronic device 101 is an in-folding type electronic device, the surface of the first display area 251 and the surface of the second display area 252 of the flexible display 250 may face each other while forming a narrow angle (e.g., between 0 degrees and 10 degrees). At least a portion of the folding area 253 may be formed as a curve having a predetermined curvature. According to an embodiment, the hinge module (e.g., the hinge module 300 of FIG. 6A) described below may be applied to the in-folding type electronic device.

According to an embodiment, when the electronic device 101 is an out-folding type electronic device, the first rear cover 215 and the second rear cover 225 may face each other while forming a narrow angle (e.g., between 0 degrees and 10 degrees) therebetween. Further, the surface of the first display area 251 and the surface of the second display area 252 of the flexible display 250 may form a wide angle (e.g., between 350 degrees and 360 degrees) therebetween. At least a portion of the folding area 253 may be formed as a curve having a predetermined curvature. According to an embodiment, the hinge module (e.g., the hinge module 300 of FIG. 6A) described below may be applied to the out-folding type electronic device.

According to an embodiment, the electronic device 101 may be an electronic device including both the in-folding type and the out-folding type. For example, in the fully folded state of at least a portion of the electronic device 101, the display of the at least a portion may not be visually exposed to the outside, and in the fully folded state of a portion other than the at least a portion, the display of the other portion may be visually exposed to the outside. According to an embodiment, the hinge module (e.g., the hinge module 300 of FIG. 6A) described below may be applied to an electronic device including the in-folding type and the out-folding type.

According to an embodiment, when the electronic device 101 is in the intermediate state, the first housing 210 and the second housing 220 may be disposed at a certain angle. The surface of the first display area 251 and the surface of the second display area 252 of the flexible display 250 may form an angle larger than that in the folded state and smaller than that in the unfolded state. The folding area 253 may at least partially have a curved surface with a predetermined curvature and, in this case, the curvature may be smaller than that when it is in the folded state.

According to an embodiment, the first housing 210 may include first housing holes 281 and 283. According to an embodiment, the first housing holes 281 and 283 may include a1-1th housing hole 281 formed in the 1-2th side surface 211b of the first housing 210 and a 1-2th housing hole 283 formed in the 1-3th side surface 211c of the first housing 210.

According to an embodiment, the 1-2th side surface 211b of the first housing 210 may include a 1-1th segmenter 214a formed of a non-metallic material. According to an embodiment, a pair of 1-1th segmenters 214a spaced apart from each other may be provided. According to an embodiment, the 1-1th housing hole 281 may be formed between the pair of 1-1th segmenters 214a.

According to an embodiment, the 1-3th side surface 211c of the first housing 210 may include a 1-2th segmenter 214b formed of a non-metallic material. According to an embodiment, a pair of 1-2th segmenters 214b spaced apart from each other may be provided. According to an embodiment, the 12th housing hole 283 may be formed between the pair of 1-2th segmenters 214b.

According to an embodiment, the number of at least one 1-1th housing hole 281 may be equal to the number of at least one 1-2th housing hole 283.

According to an embodiment, the 1-2th side surface 211b and the 1-3th side surface 211c may be disposed in parallel. According to an embodiment, the plurality of 1-1th housing holes 281 and the plurality of 1-2th housing holes 283 may be disposed to overlap each other with respect to the length direction (e.g., Y-axis direction of FIG. 4) of the electronic device 101. For example, the plurality of 1-1th housing holes 281 may be disposed to correspond to the plurality of 1-2th housing holes 283, respectively, in the length direction (e.g., the Y axis direction of FIG. 4) of the electronic device 101.

According to an embodiment, the plurality of 1-1th housing holes 281 may be disposed on a straight line with respect to the width direction (e.g., the X axis direction of FIG. 4) of the electronic device 101 (or first housing 210). According to an embodiment, the plurality of 1-2th housing holes 283 may be disposed on a straight line with respect to the width direction (e.g., the X axis direction of FIG. 4) of the electronic device 101 (or first housing 210).

According to an embodiment, the second housing 220 may include second housing holes 282 and 284. According to an embodiment, the second housing holes 282 and 284 may include a 2-1th housing hole 282 formed in the 2-2th side surface 221b of the second housing 220 and a 2-2th housing hole 284 formed in the 2-3th side surface 211c of the second housing 220.

According to an embodiment, the 2-2th side surface 221b of the second housing 220 may include a 2-1th segmenter 224a formed of a non-metallic material. According to an embodiment, a pair of 2-1th segmenters 224a spaced apart from each other may be provided. According to an embodiment, a portion of the 2-1th housing hole 282 may be formed between the pair of 2-1th segmenters 224a, and the remaining portion of the 2-1th housing hole 282 may be formed between the folding axis A (or the hinge assembly 230) and any one of the 2-1th segmenters 224a.

According to an embodiment, the 2-3th side surface 221c of the second housing 220 may include a 2-2th segmenter 224b formed of a non-metallic material. According to an embodiment, a pair of 2-2th segmenters 224b spaced apart from each other may be provided. According to an embodiment, the 2-1th housing hole 282 may be formed between the pair of 2-2th segmenters 224b.

According to an embodiment, the 2-3th side surface 221c of the second housing 220 may include a connection terminal 289 (e.g., the connection terminal 178 of FIG. 1).

In the following description of the drawings, illustrated is a spatial coordinate system defined by an X-axis, a Y-axis and a Z-axis orthogonal to each other. Here, the X axis may indicate a width direction of the electronic device, the Y axis may indicate a length direction of the electronic device, and the Z axis may indicate a height (or thickness) direction of the electronic device. In describing an embodiment of the disclosure, the 'first direction and the second direction' may mean directions parallel to the Z-axis.

FIG. 4 is an exploded perspective view illustrating an electronic device according to an embodiment of the disclosure.

The embodiment of FIG. 4 may be combined with the embodiments of FIGS. 1 to 3 or the embodiments of FIGS. 5 to 11B.

Referring to FIG. 4, an electronic device 101 (e.g., the electronic device 101 of FIGS. 1 to 3) may include a foldable housing 201, a first housing 210, a second housing 220, a hinge assembly 230, a flexible display 250, a first printed circuit board 241, a second printed circuit board 242, a first battery 251, a second battery 252, a waterproof member 260, and/or an acoustic housing 270.

The configuration of the foldable housing 201, the first housing 210, the second housing 220, the hinge assembly 230, and the flexible display 250 of FIG. 4 may be identical in whole or part to the configuration of the foldable housing 201, the first housing 210, the second housing 220, the hinge assembly 230, and the flexible display 250 of FIGS. 2 and 3.

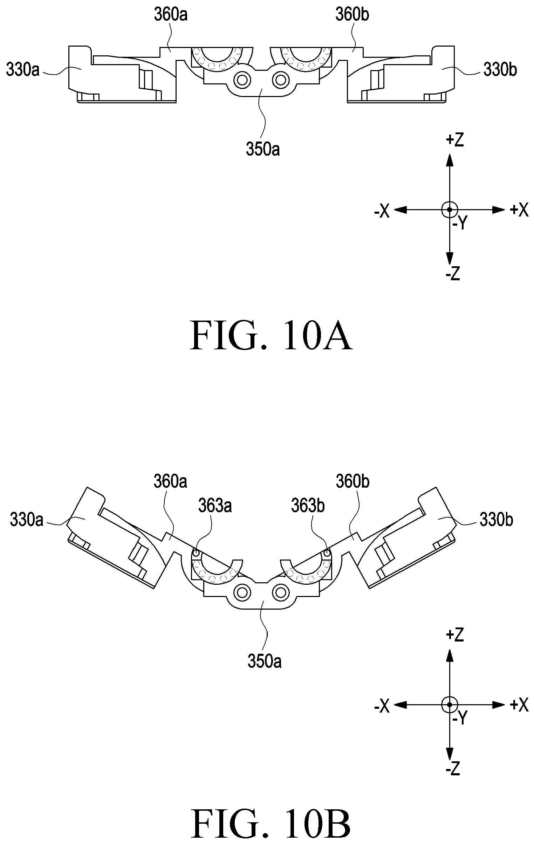

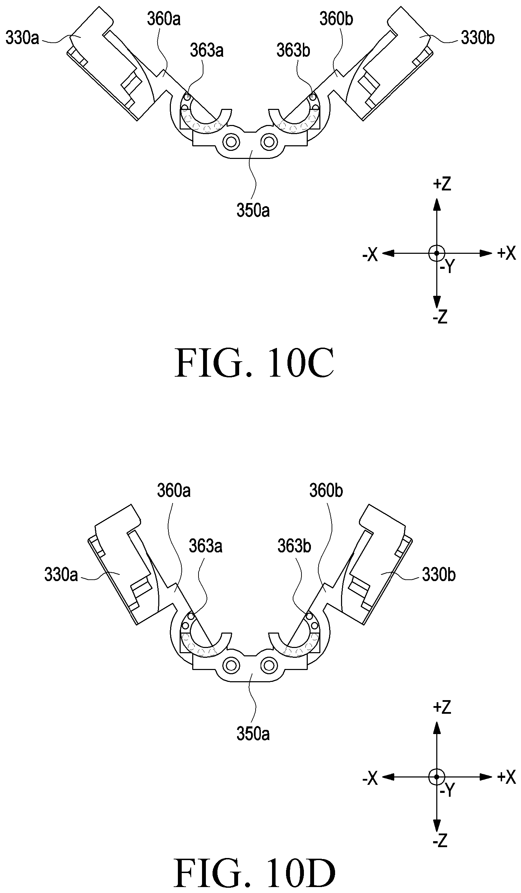

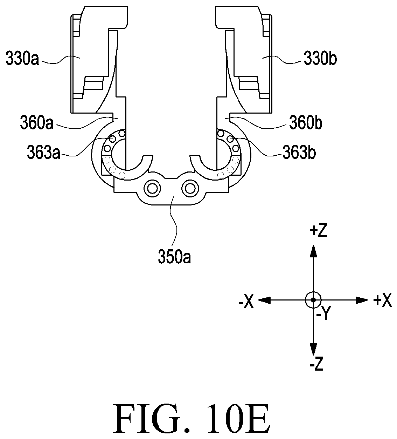

According to an embodiment, the electronic device 101 may include various electronic components (or electrical components) disposed inside or outside the first housing 210 and the second housing 220. The various electronic components may include, e.g., a processor (e.g., the processor 120 of FIG. 1), a memory (e.g., the memory 130 of FIG. 1), an input module (e.g., the input module 150 of FIG. 1), a sound output module (e.g., the sound output module 155 of FIG. 1 or the sound output module 276 of FIG. 10), a display 250 (e.g., the display module 160 of FIG. 1), an audio module (e.g., the audio module 170 of FIG. 1), a sensor (e.g., the sensor module 176 of FIG. 1), an interface (e.g., the interface 177 of FIG. 1), a connecting terminal (e.g., the connecting terminal 178 of FIG. 1 or the connecting terminal 289 of FIG. 2), a haptic module (e.g., the haptic module 179 of FIG. 1), a camera module (e.g., the camera module 180 of FIG. 1), a power management module (e.g., the power management module 188 of FIG. 1), batteries 251 and 252 (e.g., the battery 189 of FIG. 1), a communication module (e.g., the communication module 190 of FIG. 1), a subscriber identification module (e.g., the subscriber identification module 196 of FIG. 1), or an antenna module (e.g., the antenna module 197 of FIG. 1). The electronic components may be appropriately separated and disposed in the inner or outer space of the first housing 210 and the second housing 220. At least one (e.g., the connecting terminal 178) of the components may be omitted from the electronic device 101, or one or more other components may be added in the electronic device 101. Further, some of these components may be integrated into one component.

According to an embodiment, the electronic device 101 may be a foldable electronic device, and may include a plurality of batteries to supply and store power required for driving to electronic components. For example, the electronic device 1200 may include a first battery 251 and a second battery 252 disposed in the first housing 210 and the second housing 220, respectively.

According to an embodiment, the first housing 210 may include a 1-1th side surface 211a (e.g., the 1-1th side surface 211a of FIGS. 2 to 3), a 1-2th side surface 211b (e.g., the 1-2th side surface 211b of FIGS. 2 to 3), a 1-3th side surface 211c (e.g., the 1-3th side surface 211c of FIGS. 2 to 3), and/or a first plate 213.

According to an embodiment, the second housing 220 may include a 2-1th side surface 221a (e.g., the 2-1th side surface 221a of FIGS. 2 to 3), a 2-2th side surface 221b (e.g., the 2-2th side surface 221b of FIGS. 2 to 3), a 2-3th side surface 221c (e.g., the 2-3th side surface 221c of FIGS. 2 to 3), and/or a second plate 223.

According to an embodiment, the electronic device 101 may be a foldable electronic device, and may include a first plate 213 and/or a second plate 223 for disposing components in the first housing 210 and the second housing 220. In an embodiment, the first plate 213 may be interpreted as a component of the first housing 210, and the second plate 223 may be interpreted as a component of the second housing 220. In an embodiment, the first plate 213 may be interpreted as a separate component from the first housing 210, and the second plate 223 may be interpreted as a separate component from the second housing 220. Various electronic components and/or printed circuit boards 241 and 242 may be disposed on the first plate 213 and/or the second plate 223. According to an embodiment, the first plate 213 and the first printed circuit board 241 may be disposed in the first housing 210, and the second plate 223 and the second printed circuit board 242 may be disposed in the second housing 220. The first plate 213 may include a first surface facing in the first direction. The second plate 223 may include a second surface facing in the second direction. The first plate 213 and the second plate 223 may be folded or unfolded with respect to each other by the hinge structure 231 formed corresponding to the folding area 253 of the flexible display 250 and be formed to face each other in the folded state and, in the unfolded state, be formed so that the first surface and the second surface face in the same direction.

According to an embodiment, the first printed circuit board 241 may be disposed in the first waterproof area 261-1 formed by the first waterproof member 261.

According to an embodiment, the flexible display 250 may be disposed in the first housing 210 and the second housing 220. According to an embodiment, the first display area 251 may be disposed on the first housing 210 (or the first plate 213), and the second display area 252 may be disposed on the second housing 220 (or the second plate 223). According to an embodiment, the folding area 253 may connect the first display area 251 and the second display area 252 and may be disposed on the hinge structure 231.

According to an embodiment, the first printed circuit board 241 may be disposed under the first plate 213 (in the -Z-axis direction), and the second printed circuit board 242 may be disposed under the second plate 223 (in the -Z-axis direction).

According to an embodiment, signals of the processor for implementing various functions and operations of the electronic device 101 may be transferred through various conductive lines 243 and/or connecting member (connector) formed on the printed circuit boards 241 and 242.

According to an embodiment, the foldable housing 201 may include a first housing 210, a second housing 220, a first rear cover 215, a second rear cover 225, and a hinge assembly 230.

According to an embodiment, the flexible display 250 may include a display panel. In an embodiment, the first plate 213 and the second plate 223 may be disposed between the display panel and the first printed circuit board 241 and the second printed circuit board 242. The hinge assembly 230 may be disposed between the first plate 223 and the second plate 223.

According to an embodiment, the electronic device 101 may further include a sub display 218 (e.g., the display module 160 of FIG. 1) disposed between the first housing 210 and the first rear cover 215. According to an embodiment, the sub display 218 may include a display panel. According to an embodiment, the sub display 218 may be coupled to the first rear cover 215. According to an embodiment, the sub display 218 may be coupled to the first printed circuit board 241. For example, the sub display 218 may be visually exposed to the outside of the electronic device 101 through a first rear area (e.g., the first rear area 216 of FIG. 2) of the first rear cover 215.

According to an embodiment, the hinge assembly 230 may include a hinge structure 231 and a hinge cover 232. According to an embodiment, the hinge structure 231 may include a hinge module (e.g., the hinge module 231-1 of FIG. 5) and a hinge plate (e.g., the hinge plate 231-2 of FIG. 5). According to an embodiment, the hinge cover 232 may cover the hinge structure 231.

According to an embodiment, it may connect the first housing 210 and the second housing 220 to be rotatable relative to each other.

According to an embodiment, the electronic device 101 may include a first printed circuit board 241 and a second printed circuit board 242. The first printed circuit board 241 and the printed second circuit board 242 may be disposed in a space formed by the first plate 1241, the second plate 223, the first housing 210, the second housing 220, the first rear cover 215, and the second rear cover 225. Components for implementing various functions of the electronic device 101 may be disposed on the first printed circuit board 241 and the second printed circuit board 242. According to an embodiment, each of the first printed circuit board 241 and the second printed circuit board 242 may include any one of a printed circuit board (PCB), a flexible printed circuit board (PCB), or a rigid-flexible PCB (RF-PCB).

According to an embodiment, the first housing 210 and the second housing 220 may be assembled to be coupled to two opposite sides of the hinge assembly 230 in a state in which the first plate 213 and the second plate 223 and the flexible display 250 are coupled. For example, the first housing 210 may be coupled by sliding on one side of the hinge assembly 230, and the second housing 220 may be coupled by sliding on the other side of the hinge assembly 230.

According to an embodiment, the waterproof member 260 may be disposed inside the electronic device 101. According to an embodiment, the waterproof member 260 may include a first waterproof member 261, a second waterproof member 262, a third waterproof member 263, and/or a fourth waterproof member 264.

According to an embodiment, the first waterproof member 261 may be disposed between the first housing 210 and the flexible display 250. According to an embodiment, the first waterproof member 261 may be disposed between the first plate 213 and the first display area 251. According to an embodiment, the first waterproof member 261 may be formed of a waterproof tape. According to an embodiment, the first waterproof member 261 may be bonded to the first housing 210 and/or the first plate 213, and may be bonded to the flexible display 250 (e.g., the first display area 251). According to an embodiment, the first waterproof member 261 may have a closed loop shape. For example, the first waterproof member 261 may include at least one closed loop area. According to an embodiment, the first waterproof member 261 may include a waterproof tape, and may restrict liquid inflow from the outside of the closed loop area of the first waterproof member 261 to the inside of the closed loop area.

According to an embodiment, the first waterproof member 261 may include at least one first waterproof area 261-1. According to an embodiment, the at least one first waterproof area 261-1 may be defined and interpreted as an inside of the closed loop area of the first waterproof member 261.

According to an embodiment, the second waterproof member 262 may be disposed between the second housing 220 and the flexible display 250. According to an embodiment, the second waterproof member 262 may be disposed between the second plate 223 and the second display area 252. According to an embodiment, the second waterproof member 262 may be formed of a waterproof tape. According to an embodiment, the second waterproof member 262 may be bonded to the second housing 220 and/or the second plate 223, and may be bonded to the flexible display 250 (e.g., the second display area 252). According to an embodiment, the second waterproof member 262 may have a closed loop shape. For example, the second waterproof member 262 may include at least one closed loop area. According to an embodiment, the second waterproof member 262 may include a waterproof tape, and may restrict liquid inflow from the outside of the closed loop area of the second waterproof member 262 to the inside of the closed loop area.

According to an embodiment, the second waterproof member 262 may include at least one second waterproof area 262-1. According to an embodiment, the at least one second waterproof area 262-1 may be defined and interpreted as the inside of a closed loop area of the second waterproof member 262.

According to an embodiment, the third waterproof member 263 may be disposed between the first housing 210 and the first rear cover 215. According to an embodiment, the third waterproof member 263 may be disposed between the first plate 213 and the sub display 218. According to an embodiment, the third waterproof member 263 may be formed of a waterproof tape. According to an embodiment, the third waterproof member 263 may be bonded to the first housing 210 and/or the first plate 213, and may be bonded to the first rear cover 215 and/or the sub display 218. According to an embodiment, the third waterproof member 263 may have a closed loop shape. For example, the third waterproof member 263 may include at least one closed loop area. According to an embodiment, the third waterproof member 261 may include a waterproof tape, and may restrict liquid inflow from the outside of the closed loop area of the third waterproof member 261 to the inside of the closed loop area.

According to an embodiment, the third waterproof member 263 may include at least one third waterproof area 263-1. According to an embodiment, the at least one third waterproof area 263-1 may be defined and interpreted as an inside of the closed loop area of the third waterproof member 263.

According to an embodiment, the fourth waterproof member 264 may be disposed between the second housing 220 and the second rear cover 225. According to an embodiment, the fourth waterproof member 264 may be disposed between the second plate 223 and the second rear cover 225. According to an embodiment, the fourth waterproof member 264 may be formed of a waterproof tape. According to an embodiment, the fourth waterproof member 264 may be bonded to the second housing 220 and/or the second plate 223, and may be bonded to the second rear cover 215. According to an embodiment, the fourth waterproof member 264 may have a closed loop shape. For example, the fourth waterproof member 264 may include at least one closed loop area. According to an embodiment, the fourth waterproof member 264 may include a waterproof tape, and may restrict liquid inflow from the outside of the closed loop area of the fourth waterproof member 264 to the inside of the closed loop area.

According to an embodiment, the fourth waterproof member 264 may include at least one fourth waterproof area 264-1. According to an embodiment, the at least one fourth waterproof area 264-1 may be defined and interpreted as an inside of the closed loop area of the fourth waterproof member 264.

According to an embodiment, the first waterproof member 261, the second waterproof member 262, the third waterproof member 263, and the fourth waterproof member 264 may be disposed not to contact the hinge assembly 230.

According to an embodiment, as the waterproof member 260 is disposed inside the electronic device 101, the electronic device 101 may restrict the inflow of liquid from the outside of the electronic device 101 into the electronic device 101.

According to an embodiment, the electronic device 101 may include an acoustic housing 270 coupled to the first plate 213. According to an embodiment, a sound output module (e.g., the sound output module 155 of FIG. 1) may be disposed in the acoustic housing 270.

According to an embodiment, the acoustic housing 270 may be disposed between the first plate 213 and the first rear cover 215. According to an embodiment, the acoustic housing 270 may be disposed adjacent to an inner wall of the 1-3th side surface 211c.

According to an embodiment, the sound output module disposed in the acoustic housing 270 may output sound to the outside of the electronic device 101 through at least a portion of a duct of the acoustic housing 270 and a second housing hole (e.g., the second housing hole 283 of FIGS. 2 and 3) formed in the 1-3th side surface 211c.

FIG. 5 is a view illustrating an electronic device and hinge modules according to an embodiment of the disclosure.

The embodiment of FIG. 5 may be combined with the embodiments of FIGS. 1 to 4 or the embodiments of FIGS. 6A to 22.

Referring to FIG. 5, an electronic device 101 (e.g., the electronic device 101 of FIGS. 1 to 4) may include a first housing 210, a second housing 220, a hinge structure 231, or a hinge cover 232.

The configuration of the first housing 210, the second housing 220, the hinge structure 231, or the hinge cover 232 of FIG. 5 may be identical in whole or part to the configuration of the first housing 210, the second housing 220, the hinge structure 231, or the hinge cover 232 of FIG. 4.

According to an embodiment, the first housing 210 may include a 1-1th side surface 211a (e.g., the 1-1th side surface 211a of FIG. 4), a 1-2th side surface 211b (e.g., the 1-2th side surface 211b of FIG. 4), a 1-3th side surface 211c (e.g., the 1-3th side surface 211c of FIG. 4), or a first plate 213 (e.g., the first plate 213 of FIG. 4). According to an embodiment, the second housing 220 may include a 2-1th side surface 221a (e.g., the 2-1th side surface 221a of FIG. 4), a 2-2th side surface 221b (e.g., the 2-2th side surface 221b of FIG. 4), a 2-3th side surface 221c (e.g., the 2-3th side surface 221c of FIG. 4), or a second plate 223 (e.g., the second plate 223 of FIG. 4).

According to an embodiment, the hinge structure 231 may include at least one hinge module 300 or at least one balance module 302.

According to an embodiment, the at least one hinge module 300 may rotatably connect the first housing 210 and the second housing 220. According to an embodiment, at least a portion of the at least one hinge module 300 may be coupled to the hinge cover 232.

According to an embodiment, the at least one hinge module 300 may include a first hinge module 300a and a second hinge module 300b. For example, the first hinge module 300a and the second hinge module 300b may be coupled to two opposite ends, respectively, (e.g., two opposite end portions in the Y-axis direction of FIG. 5) of the hinge cover 232.

According to an embodiment, the first hinge module 300a and the second hinge module 300b may rotatably connect the first housing 210 and the second housing 220, respectively, with respect to each other. The first hinge module 300a and the second hinge module 300b may include substantially the same components, but are not limited thereto.

According to an embodiment, the at least one hinge module 300 may not include any one of the first hinge module 300a or the second hinge module 300b, or may further include a separate hinge module.

According to an embodiment, the at least one balance module 302 may include a first balance module 302a and a second balance module 302b. According to an embodiment, the first balance module 302a and the second balance module 302b may be disposed between the first hinge module 300a and the second hinge module 300b.

According to an embodiment, the first balance module 302a may be coupled to the hinge cover 232 and the first plate 213. The second balance module 302b may be coupled to the hinge cover 232 and the second plate 223. According to an embodiment, the first balance module 302a and the second balance module 302b may stably support the first housing 210 and the second housing 220 when the first housing 210 and the second housing 220 rotate relative to each other.

In the following drawings, the first hinge module 300a is described as an example to describe the at least one hinge module 300, but the description thereof may be equally applied to and understood for the second hinge module 300b.

FIG. 6A is a perspective view illustrating a coupled hinge module according to an embodiment of the disclosure.

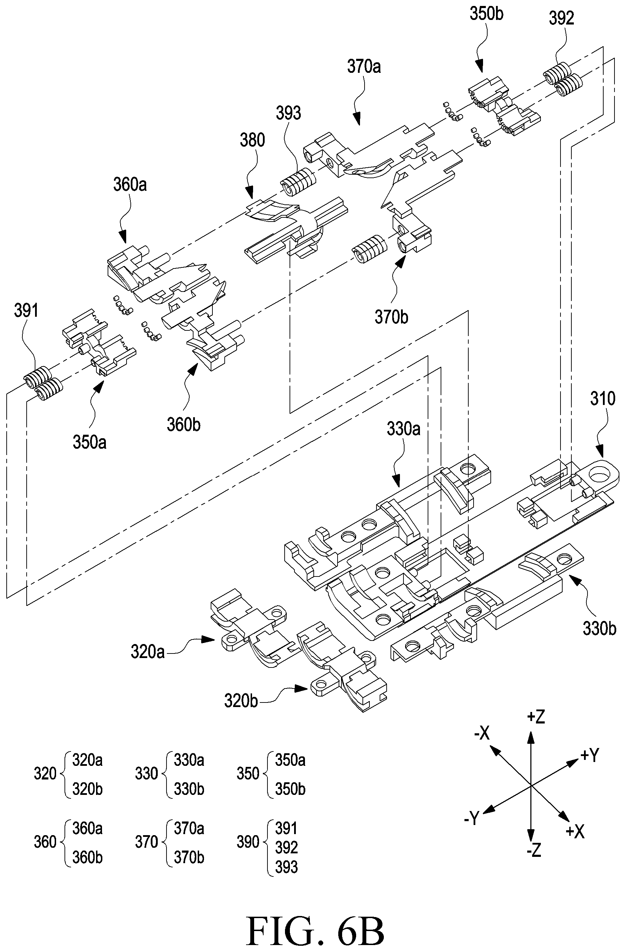

FIGS. 6B to 6D are exploded perspective views illustrating a hinge module according to an embodiment of the disclosure.

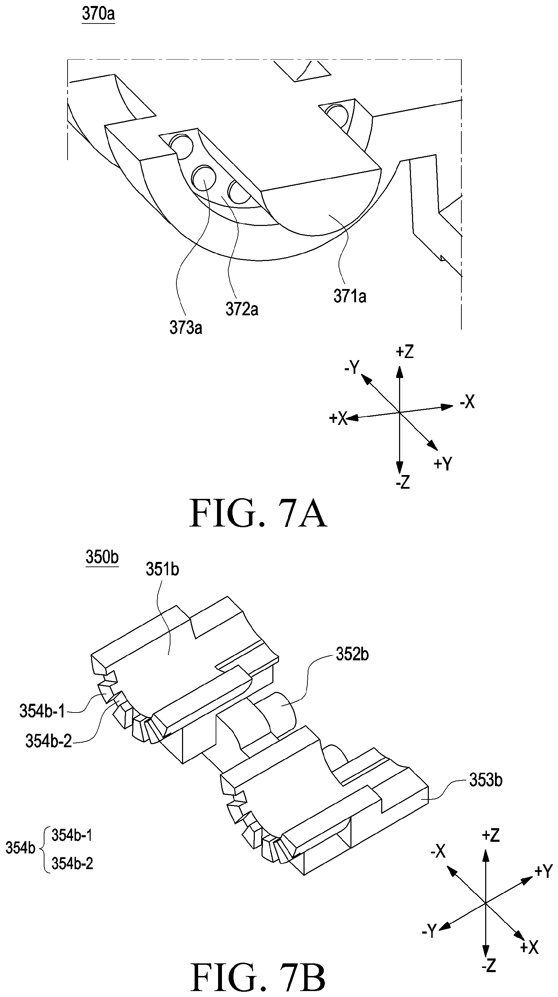

The embodiments of FIGS. 6A to 6D may be combined with the embodiments of FIGS. 1 to 5, or the embodiments of FIGS. 7A to 22.

The hinge module 300 illustrated in FIGS. 6A to 6D represents the first hinge module 300a of FIG. 5, but the description of the hinge module 300 described with reference to FIGS. 6A to 6D may be equally applied to and understood for the second hinge module 300b of FIG. 5.

Referring to FIGS. 6A to 6D, a hinge module 300 (e.g., the hinge module 300 or the first hinge module 300a of FIG. 5) may include a hinge plate 310, at least one rotation member 320, at least one guide bracket 330, at least one hinge bracket 350, at least one rotation cam member 360 or 370, a slide cam member 380, or at least one elastic member 390.

According to an embodiment, the hinge module 300 may provide a pair of folding axes A1 and A2. According to an embodiment, the pair of folding axes A1 and A2 may be disposed parallel to each other at a designated interval. The interval between the pair of folding axes A1 and A2 may determine the radius of curvature of the folding area (e.g., the folding area 253 of FIG. 4) in the folded state (e.g., FIG. 3). For example, even in the folded state, the folding axes A1 and A2 may be disposed at a designated interval so that the folding area (e.g., the folding area 253 of FIG. 4) may have an appropriate radius of curvature.

According to an embodiment, the hinge plate 310 may be coupled to a hinge cover (e.g., the hinge cover 232 of FIG. 5). According to an embodiment, when the electronic device (e.g., the electronic device 101 of FIGS. 2 to 5) is in the folded state (e.g., FIG. 3), the hinge plate 310 and/or the hinge module 300 may not be exposed to the outside of the electronic device 101 by the hinge cover (e.g., the hinge cover 232 of FIG. 5).

According to an embodiment, the hinge plate 310 may be coupled to at least a portion of the hinge cover (e.g., the hinge cover 232 of FIG. 5). The hinge plate 310 may provide a coupling structure where the remaining components of the hinge module 300 may be disposed.

According to an embodiment, the hinge plate 310 may include a pair of slot structures 311 where the slide cam member 380 is slidably coupled. The slot structures 311 may protrude from at least a portion of the hinge plate 310. The slot structures 311 may be spaced apart from each other in the length direction (e.g., the Y-axis direction of FIGS. 6A to 6D) of the electronic device (e.g., the electronic device 101 of FIG. 5). According to an embodiment, at least a portion 381 of the slide cam member 380 may be inserted into the slot structures 311. According to an embodiment, at least a portion 381 of the slide cam member 380 may be inserted into the slot structures 311, thereby restricting the slide cam member 380 from escaping off the hinge plate 310.

According to an embodiment, the hinge plate 310 may include a supporting structure for supporting the at least one hinge bracket 350. The supporting structure may include a first supporting structure 312a and 313a for supporting the first hinge bracket 350 and a second supporting structure 312b and 313b for supporting the second hinge bracket 350b.

According to an embodiment, the first supporting structure 312a and 313a may include a pair of first insertion structures 313a and a pair of first protruding structures 312a. The pair of first insertion structures 313a may be spaced apart from each other in the width direction (e.g., the X-axis direction of FIGS. 6A to 6D) of the electronic device (e.g., the electronic device 101 of FIG. 5). According to an embodiment, at least a portion 353a of the first hinge bracket 350a may be inserted into the first insertion structures 313a. For example, the first insertion structures 313a may slidably support the first hinge bracket 350a. The pair of first protruding structures 312a may be spaced apart from each other in the width direction (e.g., the X-axis direction of FIGS. 6A to 6D) of the electronic device (e.g., the electronic device 101 of FIG. 5). According to an embodiment, the pair of first protruding structures 312a may have a pin shape. According to an embodiment, a pair of first elastic members 391 may be disposed in the pair of first protruding structures 312a, respectively.

According to an embodiment, the second supporting structure 312b and 313b may include a pair of second insertion structures 313b and a pair of second protruding structures 312b. The pair of second insertion structures 313b may be spaced apart from each other in the width direction (e.g., the X-axis direction of FIGS. 6B to 6D) of the electronic device (e.g., the electronic device 101 of FIG. 5). According to an embodiment, at least a portion 353b of the second hinge bracket 350b may be inserted into the second insertion structures 313b. For example, the second insertion structures 313b may slidably support the second hinge bracket 350b. The pair of second protruding structures 312b may be spaced apart from each other in the width direction (e.g., the X-axis direction of FIGS. 6B to 6D) of the electronic device (e.g., the electronic device 101 of FIG. 5). According to an embodiment, the pair of second protruding structures 312b may have a pin shape. According to an embodiment, a pair of second elastic members 392 may be disposed in the pair of second protruding structures 312b, respectively.

According to an embodiment, the hinge plate 310 may include a first guide structure 314a or a second guide structure 314b. According to an embodiment, at least a portion of the first guide structure 314a and the second guide structure 314b may have an arc shape.

According to an embodiment, at least a portion 321a of the first rotation member 320a may be inserted into the first guide structure 314a. The first guide structure 314a may guide rotation of the first rotation member 320a. At least a portion 321b of the second rotation member 320b may be inserted into the second guide structure 314b. The second guide structure 314b may guide rotation of the second rotation member 320b.

According to an embodiment, the at least one rotation member 320 may be rotatably coupled to the hinge plate 310. According to an embodiment, the at least one rotation member 320 may include a first rotation member 320a and a second rotation member 320b.

According to an embodiment, the first rotation member 320a may include a 1-1th rotation portion 321a, a 1-2th rotation portion 322a, and a first fixed portion 323a. For example, the 1-1th rotation portion 321a may be inserted into the first guide structure 314a of the hinge plate 310. According to an embodiment, the 1-2th rotation portion 322a may be inserted into at least a portion 333a of the first guide bracket 330a. According to an embodiment, the first fixed portion 323a may be fixed to the first plate (e.g., the first plate 213 of FIG. 5) through a coupling member (e.g., a bolt or a pin). According to an embodiment, the first rotation member 320a may stably support the rotation of the first housing (e.g., the first housing 210 of FIG. 5).

According to an embodiment, the second rotation member 320b may include a 2-1th rotation portion 321b, a 2-2th rotation portion 322b, and a second fixed portion 323b. For example, the 2-1th rotation portion 321b may be inserted into the second guide structure 314b of the hinge plate 310. According to an embodiment, the 2-2th rotation portion 322b may be inserted into at least a portion 333b of the second guide bracket 330b. According to an embodiment, the second fixed portion 323b may be fixed to the second plate (e.g., the second plate 223 of FIG. 5) through a coupling member (e.g., a bolt or a pin). According to an embodiment, the second rotation member 320b may stably support rotation of the second housing (e.g., the second housing 220 of FIG. 5).

According to an embodiment, the at least one guide bracket 330 may include a first guide bracket 330a and a second guide bracket 330b.

According to an embodiment, at least a portion of the first guide bracket 330a may be fixed to the first plate (e.g., the first plate 213 of FIG. 5). According to an embodiment, the first guide bracket 330a may include a 2-1th insertion structure 331a, a 2-2th insertion structure 332a, or a 2-3th insertion structure 333a.

According to an embodiment, the 2-1th insertion structure 331a may be inserted into at least a portion 366a of the 1-1th rotation cam member 360a. At least a portion of the 2-1th insertion structure 331a may have an arc shape. According to an embodiment, the 2-2th insertion structure 332a may be inserted into at least a portion 376a of the 2-1th rotation cam member 370a. At least a portion of the 2-2th insertion structure 332a may have an arc shape.

According to an embodiment, the 2-3th insertion structure 333a may be inserted into the 1-2th rotation portion 322a of the first rotation member 320a. A pair of 2-3th insertion structures 333a may be provided, and at least a portion thereof may have an arc shape.

According to an embodiment, at least a portion of the second guide bracket 330b may be fixed to the second plate (e.g., the second plate 223 of FIG. 5). According to an embodiment, the second guide bracket 330b may include a 3-1th insertion structure 331b, a 3-2th insertion structure 332b, or a 3-3th insertion structure 333b.

According to an embodiment, the 3-1th insertion structure 331b may be inserted into at least a portion 366b of the 1-2th rotation cam member 360b. At least a portion of the 3-1th insertion structure 331b may have an arc shape. According to an embodiment, the 3-2th insertion structure 332b may be inserted into at least a portion 376b of the 2-2th rotation cam member 370b. At least a portion of the 3-2th insertion structure 332b may have an arc shape.

According to an embodiment, the 3-3th insertion structure 333b may be inserted into the 2-2th rotation portion 322b of the second rotation member 320b. A pair of 3-3th insertion structures 333b may be provided, and at least a portion thereof may have an arc shape.

According to an embodiment, the at least one hinge bracket 350 may include a first hinge bracket 350a and a second hinge bracket 350b.

According to an embodiment, the first hinge bracket 350a may be configured to guide rotation of the at least one first rotation cam member 360.

According to an embodiment, the first hinge bracket 350a may include a pair of first guide portions 351a formed in a curved shape. The 1-1th rotation shaft 361a of the 1-1th rotation cam member 360a or the 1-2th rotation shaft 361b of the 1-2th rotation cam member 360b may be rotatably seated on the first guide portions 351a.

According to an embodiment, the first hinge bracket 350a may include a pair of pin-shaped second protruding structures 352a protruding from at least a portion of the first hinge bracket 350a. According to an embodiment, the second protruding structures 352a may overlap the first protruding structures 312a of the hinge plate 310 in the length direction (e.g., the Y-axis direction of FIGS. 6A to 6D) of the electronic device (e.g., the electronic device 101 of FIG. 5).

According to an embodiment, a pair of first elastic members 391 may be disposed between the first protruding structures 312a of the hinge plate 310 and the second protruding structures 352a of the first hinge bracket 350a. The first elastic members 391 may be supported by at least a portion of the hinge plate 310 and may pressurize the first hinge bracket 350a in a first action direction (e.g., the +Y direction of FIGS. 6A to 6D).

According to an embodiment, the first hinge bracket 350a may include first facing portions 354a formed in front portions (e.g., portions facing in the +Y direction of FIGS. 6A to 6D) of the first guide portions 351a. According to an embodiment, the first facing portions 354a may be inserted into the 1-1th insertion recess 362a of the 1-1th rotation cam member 360a and the 1-2th insertion recess 362b of the 1-2th rotation cam member 360b, respectively.

According to an embodiment, the first hinge bracket 350a may include a first insertion portion 353a configured to be inserted into the first insertion structure 313a of the hinge plate 310. According to an embodiment, the first hinge bracket 350a may slide in the first action direction (e.g., the +Y direction of FIGS. 6A to 6D) with the first insertion portion 353a inserted into the first insertion structure 313a. The first hinge bracket 350a may slide in the first action direction, and the first facing portions 354a may come in tight contact with or be disposed adjacent to the magnetic members 363a and 363b of the first rotation cam member 360.

According to an embodiment, the second hinge bracket 350b may be configured to guide rotation of the at least one second rotation cam member 370.

According to an embodiment, the second hinge bracket 350b may include a pair of second guide portions 351b formed in a curved shape. The 2-1th rotation shaft 371a of the 2-1th rotation cam member 370a or the 2-2th rotation shaft 371b of the 2-2th rotation cam member 370b may be rotatably seated on the second guide portions 351b.

According to an embodiment, the second hinge bracket 350b may include a pair of pin-shaped second protruding structures 352b protruding from at least a portion of the second hinge bracket 350b. According to an embodiment, the second protruding structures 352b may overlap the second protruding structures 312b of the hinge plate 310 in the length direction (e.g., the Y-axis direction of FIGS. 6B to 6D) of the electronic device (e.g., the electronic device 101 of FIG. 5).

According to an embodiment, a pair of second elastic members 392 may be disposed between the second protruding structures 312b of the hinge plate 310 and the second protruding structures 352b of the second hinge bracket 350b. The second elastic members 392 may be supported by at least a portion of the hinge plate 310 and may pressurize the second hinge bracket 350b in a second action direction (e.g., the -Y direction of FIGS. 6B to 6D).

According to an embodiment, the second hinge bracket 350b may include second facing portions 354b formed in front portions (e.g., portions facing in the +Y direction of FIGS. 6B to 6D) of the second guide portions 351b. According to an embodiment, the second facing portions 354b may be inserted into the 2-1th insertion recess 372a of the 2-1th rotation cam member 370a and the 2-2th insertion recess 372b of the 2-2th rotation cam member 370b, respectively.

According to an embodiment, the second hinge bracket 350b may include a second insertion portion 353b configured to be inserted into the second insertion structure 313b of the hinge plate 310. According to an embodiment, the second hinge bracket 350b may slide in the second action direction (e.g., the -Y direction of FIGS. 6B to 6D) with the second insertion portion 353b inserted into the second insertion structure 313b. The second hinge bracket 350b may slide in the second action direction, and the second facing portions 354b may come in tight contact with or be disposed adjacent to the magnetic members 373a and 373b of the second rotation cam member 370.

According to an embodiment, the at least one first rotation cam member 360 may include a 1-1th rotation cam member 360a or a 1-2th rotation cam member 360b.

According to an embodiment, the 1-1th rotation cam member 360a may be disposed to be rotatable relative to the first hinge bracket 350a. According to an embodiment, the 1-1th rotation cam member 360a may include a 1-1th rotation shaft 361a rotatably disposed on any one of the first guide portions 351a of the first hinge bracket 350a.

According to an embodiment, at least a portion of the 1-1th rotation shaft 361a may have a curved shape, and the curved portion may be rotatably seated on the first guide portion 351a.

According to an embodiment, the 1-1th rotation cam member 360a may include a 1-1th insertion recess 362a disposed to surround the 1-1th rotation shaft 361a. For example, any one of the first facing portions 354a of the first hinge bracket 350a may be inserted into the 1-1th insertion recess 362a.

According to an embodiment, the 1-1th rotation cam member 360a may include 1-1th magnetic members 363a. The 1-1th magnetic members 363a may be fixed to the 1-1th insertion recess 362a and may be disposed to surround the 1-1th rotation shaft 361a.

According to an embodiment, the plurality of 1-1th magnetic members 363a may face any one of the first facing portions 354a. According to an embodiment, the plurality of 1-1th magnetic members 363a may provide a free-stop function to the electronic device (e.g., the electronic device 101 of FIG. 5) through an attaching force formed by magnetism with the first facing portion 354a.

According to an embodiment, the 1-1th rotation cam member 360a may include at least one 1-1th fixing pin 364a or 365a protruding from at least a portion thereof. According to an embodiment, the at least one 1-1th fixing pin 364a or 365a may be inserted into the at least one 2-1th fixing hole 374a or 375a formed in the 2-1th rotation cam member 370a.

According to an embodiment, the 1-1th rotation cam member 360a may include a 1-1th slit portion 366a into which the 2-1th insertion structure 331a of the first guide bracket 330a is inserted.

According to an embodiment, the 1-1th rotation cam member 360a may include a 1-2th slit portion 367a into which the 2-1th guide portion 382a of the slide cam member 380 is inserted.

According to an embodiment, the 1-2th rotation cam member 360b may be disposed to be rotatable relative to the first hinge bracket 350a. According to an embodiment, the 1-2th rotation cam member 360b may include a 1-2th rotation shaft 361b rotatably disposed on the other one of the first guide portions 351a of the first hinge bracket 350a.

According to an embodiment, at least a portion of the 1-2th rotation shaft 361b may have a curved shape, and the curved portion may be rotatably seated on the other one of the first guide portions 351a.

According to an embodiment, the 1-2th rotation cam member 360b may include a 1-2th insertion recess 362b disposed to surround the 1-2th rotation shaft 361b. For example, any one of the first facing portions 354a of the first hinge bracket 350a may be inserted into the 1-2th insertion recess 362b.

According to an embodiment, the 1-2th rotation cam member 360b may include 1-2th magnetic members 363b. The 1-2th magnetic members 363b may be fixed to the 1-2th insertion recess 362b and may be disposed to surround the 1-2th rotation shaft 361b.

According to an embodiment, the plurality of 1-2th magnetic members 363b may face the other one of the first facing portions 354a. According to an embodiment, the plurality of 1-2th magnetic members 363b may provide a free-stop function to the electronic device (e.g., the electronic device 101 of FIG. 5) through an attaching force formed by magnetism with the other one of the first facing portions 354a.

According to an embodiment, the 1-2th rotation cam member 360b may include at least one 1-2th fixing pin 364b or 365b protruding from at least a portion thereof. According to an embodiment, the at least one 1-2th fixing pin 364b or 365b may be inserted into the at least one 1-2th fixing hole 374b or 375b formed in the 2-2th rotation cam member 370b.

According to an embodiment, the 1-2th rotation cam member 360b may include a 2-1th slit portion 366b into which the 3-1th insertion structure 331b of the second guide bracket 330b is inserted.

According to an embodiment, the 1-2th rotation cam member 360b may include a 2-2th slit portion 367b into which the 2-2th guide portion 382b of the slide cam member 380 is inserted.

According to an embodiment, the at least one second rotation cam member 370 may include a 2-1th rotation cam member 370a or a 2-2th rotation cam member 370b.

According to an embodiment, the 2-1th rotation cam member 370a may be disposed to be rotatable relative to the second hinge bracket 350b. According to an embodiment, the 2-1th rotation cam member 370a may include a 2-1th rotation shaft 371a rotatably disposed on any one of the second guide portions 351b of the second hinge bracket 350b.

According to an embodiment, at least a portion of the 2-1th rotation shaft 371a may have a curved shape, and the curved portion may be rotatably seated on the second guide portion 351b.

According to an embodiment, the 2-1th rotation cam member 370a may include a 2-1th insertion recess 372a disposed to surround the 2-1th rotation shaft 371a. For example, any one of the second facing portions 354b of the second hinge bracket 350b may be inserted into the 2-1th insertion recess 372a.

According to an embodiment, the 2-1th rotation cam member 370a may include 2-1th magnetic members 373a. The 2-1th magnetic members 373a may be fixed to the 2-1th insertion recess 372a and may be disposed to surround the 2-1th rotation shaft 371a.

According to an embodiment, the plurality of 2-1th magnetic members 373a may face any one of the second facing portions 354b. According to an embodiment, the plurality of 2-1th magnetic members 373a may provide a free-stop function to the electronic device (e.g., the electronic device 101 of FIG. 5) through an attaching force formed by magnetism with the second facing portion 354b.

According to an embodiment, the 2-1th rotation cam member 370a may include at least one 2-1th fixing hole 374a or 375a recessed in at least a portion thereof. According to an embodiment, the at least one 2-1th fixing pin 364a or 365a formed in the 1-1th rotation cam member 360a may be inserted into the at least one 2-1th fixing hole 374a or 375a.

According to an embodiment, the 2-1th rotation cam member 370a may include a 3-1th slit portion 376a into which the 2-2th insertion structure 332a of the first guide bracket 330a is inserted.

According to an embodiment, the 2-1th rotation cam member 370a may include a 3-2th slit portion 377a into which the 2-1th guide portion 382a of the slide cam member 380 is inserted.

According to an embodiment, the 2-2th rotation cam member 370b may be disposed to be rotatable relative to the second hinge bracket 350b. According to an embodiment, the 2-2th rotation cam member 370b may include a 2-2th rotation shaft 371b rotatably disposed on the other one of the second guide portions 351b of the second hinge bracket 350b.

According to an embodiment, at least a portion of the 2-2th rotation shaft 371b may have a curved shape, and the curved portion may be rotatably seated on the second guide portion 351b.

According to an embodiment, the 2-2th rotation cam member 370b may include a 2-2th insertion recess 372b disposed to surround the 2-2th rotation shaft 371b. For example, any one of the second facing portions 354b of the second hinge bracket 350b may be inserted into the 2-2th insertion recess 372b.

According to an embodiment, the 2-2th rotation cam member 370b may include 2-2th magnetic members 373b. The 2-2th magnetic members 373b may be fixed to the 2-2th insertion recess 372b and may be disposed to surround the 2-2th rotation shaft 371b.

According to an embodiment, the plurality of 2-2th magnetic members 373b may face the other one of the second facing portions 354b. According to an embodiment, the plurality of 2-2th magnetic members 373b may provide a free-stop function to the electronic device (e.g., the electronic device 101 of FIG. 5) through an attaching force formed by magnetism with the second facing portion 354b.

According to an embodiment, the 2-2th rotation cam member 370b may include at least one 2-2th fixing hole 374b or 375b recessed in at least a portion thereof. According to an embodiment, the at least one 2-2th fixing pin 364b or 365b formed in the 1-2th rotation cam member 360b may be inserted into the at least one 2-2th fixing hole 374b or 375b.

According to an embodiment, the 2-2th rotation cam member 370b may include a 4-1th slit portion 376b into which the 3-1th insertion structure 331b of the second guide bracket 330b is inserted.

According to an embodiment, the 2-2th rotation cam member 370b may include a 4-2th slit portion 377b into which the 2-2th guide portion 382b of the slide cam member 380 is inserted.

According to an embodiment, the slide cam member 380 may include a slide portion 381 configured to be inserted into the slot structure 311 of the hinge plate 310. According to an embodiment, the slide portion 381 of the slide cam member 380 may be inserted into the slot structure 311.

According to an embodiment, the slide cam member 380 may include a 2-1th guide portion 382a and a 2-2th guide portion 382b. According to an embodiment, at least a portion of the 2-1th guide portion 382a and the 2-2th guide portion 382b may have a curved shape.

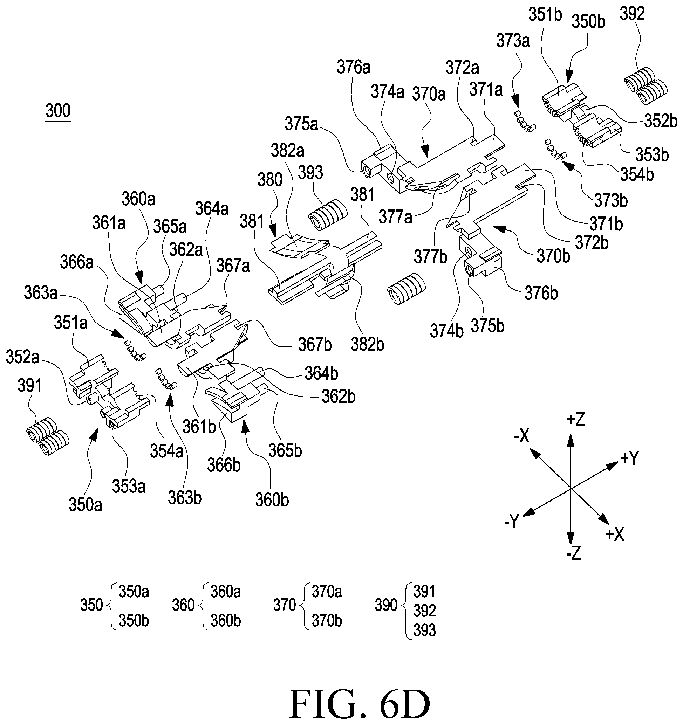

According to an embodiment, one end (e.g., the end portion facing in the -Y direction in FIG. 6D) of the 2-1th guide portion 382a may be inserted into the 1-2th slit portion 367a of the 1-1th rotation cam member 360a, and the other end (e.g., the end portion facing in the +Y direction in FIG. 6D) of the 2-1th guide portion 382a may be inserted into the 3-2th slit portion 377a of the 2-1th rotation cam member 370a.

According to an embodiment, one end (e.g., the end portion facing in the -Y direction in FIG. 6D) of the 2-2th guide portion 382b may be inserted into the 2-2th slit portion 367b of the 1-2th rotation cam member 360b, and the other end (e.g., the end portion facing in the +Y direction in FIG. 6D) of the 2-2th guide portion 382b may be inserted into the 4-2th slit portion 377b of the 2-2th rotation cam member 370b.

According to an embodiment, the 2-1th guide portion 382a may be configured to guide rotation of the 1-1th rotation cam member 360a and the 2-1th rotation cam member 370a, and the 2-2th guide portion 382b may be configured to guide rotation of the 1-2th rotation cam member 360b and the 2-2th rotation cam member 370b.

According to an embodiment, the at least one elastic member 390 may be, but is not limited to, a spring member.

According to an embodiment, the at least one elastic member 390 may include a first elastic member 391, a second elastic member 392, and a third elastic member 393.

According to an embodiment, the first elastic member 391 may be supported by the hinge plate 310 and may pressurize the first hinge bracket 350a in a first action direction (e.g., the +Y direction of FIG. 6D).

According to an embodiment, the second elastic member 392 may be supported by the hinge plate 310 and may pressurize the second hinge bracket 350b in a second action direction (e.g., the -Y direction of FIG. 6D) opposite to the first action direction.

According to an embodiment, a pair of the third elastic members 393 may be provided. According to an embodiment, any one of the pair of third elastic members 393 may be disposed between the 1-1th rotation cam member 360a and the 2-1th rotation cam member 370a, and the other one may be disposed between the 1-2th rotation cam member 360b and the 2-2th rotation cam member 370b.

According to an embodiment, the pair of third elastic members 393 may pressurize the at least one first rotation cam member 360 and the at least one second rotation cam member 370 away from each other.

For example, any one of the pair of third elastic members 393 may pressurize the 1-1th rotation cam member 360a in the second action direction (e.g., the -Y direction of FIG. 6D) and may pressurize the 2-1th rotation cam member 370a in the first action direction (e.g., the +Y direction of FIG. 6D). According to an embodiment, at least one 1-1th fixing pin 364a may be disposed inside any one of the pair of third elastic members 393.

For example, the remaining one of the pair of third elastic members 393 may pressurize the 1-2th rotation cam member 360b in the second action direction (e.g., the -Y direction of FIG. 6D) and may pressurize the 2-2th rotation cam member 370b in the first action direction (e.g., the +Y direction of FIG. 6D). According to an embodiment, at least one 2-1th fixing pin 364b may be disposed inside the remaining one of the pair of third elastic members 393.

According to an embodiment, the magnetic members 363a, 363b, 373a, and 373b may have a cylindrical shape, but are not limited thereto, and may have a polygonal column shape. Further, the magnetic members 363a, 363b, 373a, and 373b may be provided as neodymium magnets, but are not limited thereto, and may be permanent magnets arranged in a Halbach array.

FIG. 7A is a perspective view illustrating a portion of a 2-1th rotation cam member according to an embodiment of the disclosure.

FIG. 7B is a perspective view illustrating a second hinge bracket according to an embodiment of the disclosure.

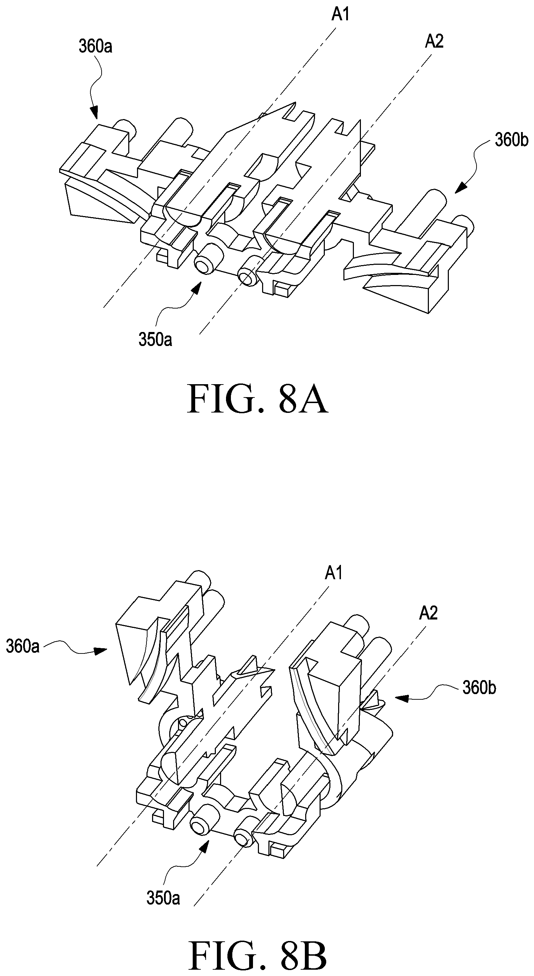

The embodiments of FIGS. 7A to 7B may be combined with the embodiments of FIGS. 1 to 6D or the embodiments of FIGS. 8A to 22.

The descriptions of the 2-1th rotation cam member and the second hinge bracket described with reference to the embodiments of FIGS. 7A to 7B may be equally applied to and understood for the 1-1th rotation cam member and the first hinge bracket, the 1-2th rotation cam member and the first hinge bracket, or the 2-2th rotation cam member and the second hinge bracket of FIGS. 6A to 6D.

According to an embodiment, the 2-1th rotation cam member 370a (e.g., the 2-1th rotation cam member 370a of FIGS. 6A to 6D) may include a 2-1th rotation shaft 371a (e.g., the 2-1th rotation shaft 371a of FIGS. 6A to 6D), a 2-1th insertion recess 372a (e.g., the 2-1th insertion recess 372a of FIGS. 6A to 6D), or a plurality of 2-1th magnetic members 373a (e.g., the plurality of 2-1th magnetic members 373a of FIGS. 6A to 6D).

According to an embodiment, the second hinge bracket 350b (e.g., the second hinge bracket 350b of FIGS. 6A to 6D) may include second guide portions 351b (e.g., the second guide portions 351b of FIGS. 6A to 6D), a second protruding structure 352b (e.g., the second protruding structure 352b of FIGS. 6A to 6D), a second insertion portion 353b (e.g., the second insertion portion 353b of FIGS. 6A to 6D), or second facing portions 354b (e.g., the second facing portions 354b of FIGS. 6A to 6D).

According to an embodiment, the second facing portions 354b may be formed at front end portions of the second guide portions 351b. According to an embodiment, any one of the second facing portions 354b may be inserted into the 2-1th insertion recess 372a.

According to an embodiment, at least a portion of the second facing portion 354b may be formed of a metallic material, thereby forming an attaching force with the 2-1th magnetic members 373a by magnetism.

According to an embodiment, the second facing portion 354b may include a protruding portion 354b-1 at least partially protruding, and a concave portion 354b-2 formed to be concave as compared with other portions. According to an embodiment, in a state of being inserted into the second facing portion 354b, the protruding portion 354b-1 may be disposed further adjacent to the 2-1th magnetic members 373a than the concave portion 354b-2.

FIG. 8A is a perspective view illustrating a state in which a first hinge bracket and at least one first rotation cam member are disposed in a first state according to an embodiment of the disclosure.

FIG. 8B is a perspective view illustrating a state in which a first hinge bracket and at least one first rotation cam member are disposed in a second state according to an embodiment of the disclosure.

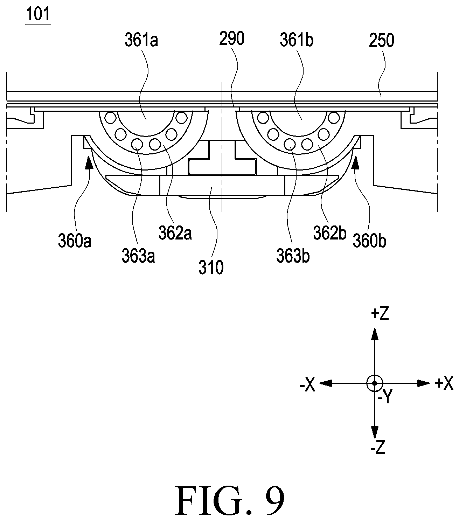

The embodiments of FIGS. 8A to 8B may be combined with the embodiments of FIGS. 1 to 7B or the embodiments of FIGS. 9 to 22.

The descriptions of the first hinge bracket and the at least one first rotation cam member described with reference to the embodiments of FIGS. 8A to 8B may be equally applied to and understood for the second hinge bracket and the at least one second rotation cam member of FIGS. 6A to 6D.

Referring to FIGS. 8A to 8B, the hinge structure (e.g., the hinge structure 300 of FIGS. 6A to 6B) may include a first hinge bracket 350a and at least one first rotation cam member (e.g., the at least one first rotation cam member 360 of FIGS. 6A to 6D). According to an embodiment, the at least one first rotation cam member may include a 1-1th rotation cam member 360a (e.g., the 1-1th rotation cam member 360a of FIGS. 6A to 6D) or a 1-2th rotation cam member 360b (e.g., the 1-2th rotation cam member 360b of FIGS. 6A to 6D).

FIG. 8A illustrates an arrangement relationship between a first hinge bracket 350a, a 1-1th rotation cam member 360a, and a 1-2th rotation cam member 360b when an electronic device (e.g., the electronic device 101 of FIGS. 2 to 5) is in a first state (e.g., an unfolded state (e.g., FIG. 2)).

FIG. 8B illustrates an arrangement relationship between the first hinge bracket 350a, the 1-1th rotation cam member 360a, and the 1-2th rotation cam member 360b when the electronic device is in a second state (e.g., the folded state (e.g., FIG. 3)).

According to an embodiment, the 1-1th rotation cam member 360a may be rotatably connected to the first hinge bracket 350a with respect to the first folding axis A1 (e.g., the first folding axis A1 of FIG. 6A). According to an embodiment, the 1-2th rotation cam member 360b may be rotatably connected to the first hinge bracket 350a with respect to the second folding axis A2 (e.g., the second folding axis A2 of FIG. 6A).

According to an embodiment, the 1-1th rotation cam member 360a may be connected to a first guide bracket (e.g., the first guide bracket 330a of FIGS. 6A to 6D) fixed to a first plate (e.g., the first plate 213 of FIG. 5) to stably support rotation of the first plate or the first housing (e.g., the first housing 210 of FIG. 5).

According to an embodiment, the 1-2th rotation cam member 360b may be connected to a second guide bracket (e.g., the second guide bracket 330b of FIGS. 6A to 6D) fixed to the second plate (e.g., the second plate 223 of FIG. 5) to stably support rotation of the second plate or the second housing (e.g., the second housing 220 of FIG. 5).

FIG. 9 is a cross-sectional view illustrating an electronic device according to an embodiment of the disclosure.

The embodiment of FIG. 9 may be combined with the embodiments of FIGS. 1 to 8B or the embodiments of FIGS. 10A to 22.

The description of the 1-1th rotation cam member 360a and the 1-2th rotation cam member 360b described with reference to the embodiment of FIG. 9 may be equally applied and understood for the 2-1th rotation cam member 370a and the 2-2th rotation cam member 370b of FIGS. 6A to 6D.

Referring to FIG. 9, an electronic device 101 (e.g., the electronic device 101 of FIGS. 1 to 5) may include a display 250, a display cover 290, or a hinge structure (e.g., the hinge structure 300 of FIGS. 6A to 6D).

The configuration of the display 250 of FIG. 9 may be identical in whole or part to the configuration of the display 250 of FIG. 4. The components of the hinge structure of FIG. 9 may be identical in whole or part to the components of the hinge structure 300 of FIGS. 6A to 6D.

Referring to FIG. 9, the display cover 290 may be connected to the 1-1th rotation cam member 360a and the 1-2th rotation cam member 360b, and may be connected to at least a portion of one surface (e.g., the surface facing in the -Z direction in FIG. 9) of the display 250.

According to an embodiment, when the 1-1th rotation cam member 360a is rotated with respect to the first hinge bracket (e.g., the first hinge bracket 350a of FIGS. 6A to 6D), the display cover 290 may be rotated together. According to an embodiment, when the 1-2th rotation cam member 360b is rotated with respect to the first hinge bracket, the display cover 290 may be rotated together. At least a portion of the display cover 290 may be formed of a bendable material to stably support the display 250 when the folding area (e.g., the folding area 253 of FIG. 5) of the display 250 is folded.

According to an embodiment, in the 1-1th rotation cam member 360a, the 1-1th rotation shaft 361a may be rotatably supported on any one of the first guide portions (e.g., the first guide portions 351a of FIGS. 6A to 6D) of the first hinge bracket (e.g., the first hinge bracket 350a of FIGS. 6A to 6D). According to an embodiment, in the 1-1th rotation cam member 360a, any one of the first facing portions (e.g., the first facing portions 354a of FIGS. 6A to 6D) of the first hinge bracket may be inserted into the 1-1th insertion recess 362a. According to an embodiment, the plurality of 1-1th magnetic members 363a may provide a pre-stop function for the electronic device 101 by forming an attaching force with the first facing portion by magnetism.

According to an embodiment, in the 1-2th rotation cam member 360b, the 1-2th rotation shaft 361b may be rotatably supported on the remaining one of the first guide portions (e.g., the first guide portions 351a of FIGS. 6A to 6D) of the first hinge bracket (e.g., the first hinge bracket 350a of FIGS. 6A to 6D). According to an embodiment, in the 1-2th rotation cam member 360b, the remaining one of the first facing portions (e.g., the first facing portions 354a of FIGS. 6A to 6D) of the first hinge bracket may be inserted into the 1-2th insertion recess 362b. According to an embodiment, the plurality of 1-2th magnetic members 363b may provide a pre-stop function for the electronic device 101 by forming an attaching force with the first facing portion by magnetism.

For example, when the electronic device 101 is changed from the unfolded state (e.g., FIG. 2) to the folded state (e.g., FIG. 3), the 1-1th rotation shaft 361a and the 1-1th rotation cam member 360a may be rotated in a first rotation direction (e.g., the clockwise direction of FIG. 9), and the 1-2th rotation shaft 361b and the 1-2th rotation cam member 360b may be rotated in a second rotation direction (e.g., the counterclockwise direction of FIG. 9) opposite to the first rotation direction.

For example, when the electronic device 101 is changed from the folded state (e.g., FIG. 3) to the unfolded state (e.g., FIG. 3), the 1-1th rotation shaft 361a and the 1-1th rotation cam member 360a may be rotated in the second rotation direction (e.g., the counterclockwise direction of FIG. 9), and the 1-2th rotation shaft 361b and the 1-2th rotation cam member 360b may be rotated in the first rotation direction (e.g., the clockwise direction of FIG. 9) opposite to the second rotation direction.

FIGS. 10A to 10E are views illustrating a hinge structure according to an embodiment of the disclosure.

The embodiments of FIGS. 10A to 10E may be combined with the embodiments of FIGS. 1 to 9, or the embodiments of FIGS. 11 to 22.

The descriptions of the first hinge bracket, the 1-1th rotation cam member, the 1-2th rotation cam member, the first guide bracket, and the second guide bracket described with reference to FIGS. 10A to 10E may be equally applied to and understood for the second hinge bracket, the 2-1th rotation cam member, the 2-2th rotation cam member, the first guide bracket, and the second guide bracket of FIGS. 6A to 6D.

Referring to FIGS. 10A to 10E, the hinge structure (e.g., the hinge structure 300 of FIGS. 6A to 6D) may include a first hinge bracket 350a, a 1-1th rotation cam member 360a, a 1-2th rotation cam member 360b, a first guide bracket 330a, or a second guide bracket 330b.

FIGS. 10A to 10E sequentially illustrate an arrangement relationship of components of a hinge structure when an electronic device (e.g., the electronic device 101 of FIGS. 2 to 5) is changed from an unfolded state (e.g., FIG. 2) to a folded state (e.g., FIG. 3).

According to an embodiment, at least a portion of the 1-1th rotation cam member 360a may be fixed to the first guide bracket 330a, and at least a portion of the 1-2th rotation cam member 360b may be fixed to the second guide bracket 330b. According to an embodiment, the first guide bracket 330a may be coupled to at least a portion of the first housing (e.g., the first housing 210 of FIGS. 2 to 5). According to an embodiment, the second guide bracket 330b may be coupled to at least a portion of the second housing (e.g., the second housing 220 of FIGS. 2 to 5).

According to an embodiment, when the electronic device is changed from the unfolded state (e.g., FIG. 2) to the folded state (e.g., FIG. 3) or from the folded state (e.g., FIG. 3) to the unfolded state (e.g., FIG. 2), the 1-1th rotation cam member 360a and the first guide bracket 330a disposed to be rotatable relative to the first hinge bracket 350a may stably support rotation of the first housing (e.g., the first housing 210 of FIGS. 2 to 5).

According to an embodiment, when the electronic device is changed from the unfolded state (e.g., FIG. 2) to the folded state (e.g., FIG. 3) or from the folded state (e.g., FIG. 3) to the unfolded state (e.g., FIG. 2), the 1-2th rotation cam member 360b and the second guide bracket 330b disposed to be rotatable relative to the first hinge bracket 350a may stably support rotation of the second housing (e.g., the second housing 220 of FIGS. 2 to 5).

According to an embodiment, the plurality of 1-1th magnetic members 363a of the 1-1th rotation cam member 360a and the plurality of 1-2th magnetic members 363b of the 1-2th rotation cam member 360b may face the first facing portions (e.g., the first facing portions 354a of FIGS. 6A to 6D) of the first hinge bracket 350a in the length direction (e.g., the Y-axis direction of FIGS. 10A to 10E) of the electronic device.

According to an embodiment, when the electronic device is changed from the unfolded state (e.g., FIG. 2 or 10A) to the folded state (e.g., FIG. 3 or 10B), at least some of the 1-1th magnetic members 363a and at least some of the 1-2th magnetic members 363b may be disposed not to face the first facing portions in the length direction (e.g., the Y-axis direction of FIGS. 10A to 10E) of the electronic device.

According to an embodiment, when the electronic device is changed from the unfolded state to the folded state, at least some of the magnetic members 363a and 363b are disposed not to overlap the first facing portions in the length direction of the electronic device, so that the attaching force by magnetism formed by the magnetic members 363a and 363b and the first facing portions may be gradually reduced.

FIG. 11 is a view schematically illustrating an attaching force by magnetism according to an embodiment of the disclosure.

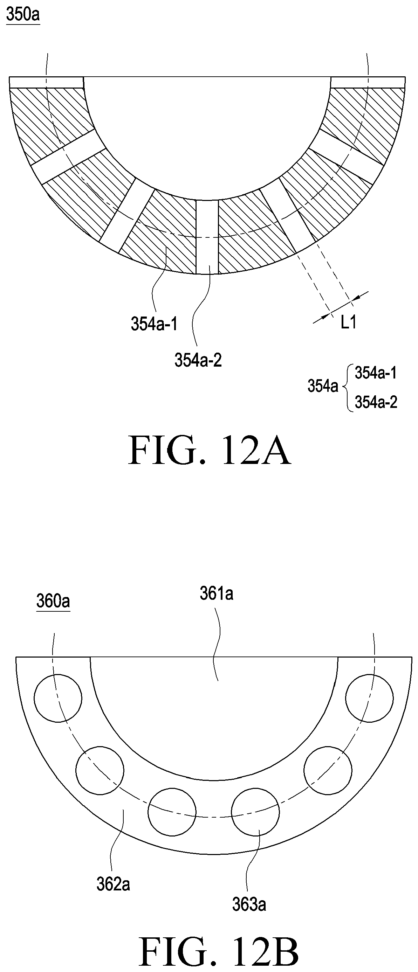

The embodiment of FIG. 11 may be combined with the embodiments of FIGS. 1 to 10, or the embodiments of FIGS. 12A to 22.

For convenience of description, a first group B1 of FIG. 11 is described by taking any one of the 2-1th magnetic members 373a of FIGS. 6A to 6D and the second facing portions 354b facing the 2-1th magnetic members 373a as an example, but the description thereof may be equally applied to and understood for other magnetic members and facing members.

A look at the second group B2 of FIG. 11 reveals that an area (hereinafter, a 'first area') is illustrated which, when the 2-1th rotation cam member (e.g., the 2-1th rotation cam member 370a of FIGS. 6A to 6D) rotates with respect to the second hinge bracket (e.g., the second hinge bracket 350b of FIGS. 6A to 6D), overlaps the 2-1th magnetic members (e.g., the second magnetic member 373a of FIGS. 6A to 6D), and the protruding portions (e.g., the protruding portions 354b-1 of FIG. 7B) of the second facing portion (e.g., the second facing portion 354b of FIGS. 6A to 6D), for each rotation angle, in the length direction (e.g., the Y-axis direction of FIG. 7B) of the electronic device.

For example, the first area when the rotation angle is 5 degrees may be smaller than when the rotation angle is 0 degrees.

When the rotation angle is 0 degrees, the protruding portions may completely cover the second magnetic members in the length direction of the electronic device, thereby maximally securing the first area, and at this time, an attaching force by magnetism formed by the second magnetic members and the second facing portion may be maximally secured.

When the rotation angle is 5 degrees, at least some of the concave portions (e.g., the concave portions 354b-2 of FIG. 7B) of the second facing portion overlap at least a portion of the second magnetic members in the length direction of the electronic device, and thus it may be identified that the size of the first area is reduced compared to when the rotation angle is 0 degrees.

When the rotation angle gradually increases (e.g., when the rotation angle increases from 0 degrees to 30 degrees), the number or size of the first areas, which are areas in which protruding portions of the second facing portion and the second magnetic members overlap each other in the length direction of the electronic device, may vary.

FIG. 12A is a view illustrating a first facing portion of a first hinge bracket according to an embodiment of the disclosure.

FIG. 12B is a view illustrating 1-1th magnetic members of a 1-1th rotation cam member according to an embodiment of the disclosure;

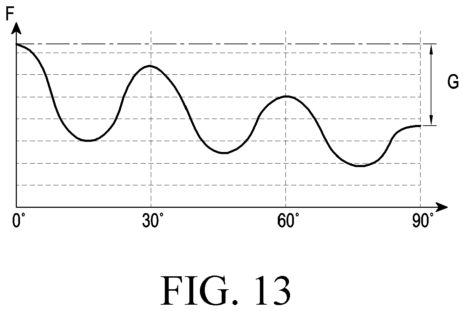

FIG. 13 is a view illustrating an attaching force by magnetism according to an embodiment of the disclosure;

The descriptions of the first hinge bracket and the 1-1th rotation cam member described with reference to FIGS. 12A to 13 may be equally applied to and understood for the first hinge bracket and the 1-2th rotation cam member, the second hinge bracket and the 2-1th rotation cam member, or the second hinge bracket and the 2-2th rotation cam member of FIGS. 6A to 6D.

Referring to FIG. 12A, the first hinge bracket 350a (e.g., the first hinge bracket 350a of FIGS. 6A to 6D) may include the first facing portion 354a (e.g., the first facing portion 354a of FIGS. 6A to 6D). The first facing portion 354a may include protruding portions 354a-1 protruding from the concave portions 354a-2, and concave portions 354a-2 concave from the protruding portions 354a-1. For example, the protruding portions 354a-1 may be defined and referred to as relief shapes, and the concave portions 354a-2 may be defined and referred to as counter-relief shapes. According to an embodiment, the plurality of protruding portions 354a-1 and the plurality of concave portions 354a-2 may be alternately disposed.

Referring to FIG. 12B, a 1-1th rotation cam member 360a (e.g., the 1-1th rotation cam member 360a of FIGS. 6A to 6D) may include a 1-1th rotation shaft 361a (e.g., the 1-1th rotation shaft 361a of FIGS. 6A to 6D), a 1-1th insertion recess 362a (e.g., the 1-1th insertion recess 362a of FIGS. 6A to 6D), or a plurality of 1-1th magnetic members 363a (e.g., the 1-1th magnetic members 363a of FIGS. 6A to 6D).

According to an embodiment, the plurality of 1-1th magnetic members 363a may be disposed to overlap the first facing portion 354a in the length direction (e.g., the Y-axis direction of FIGS. 6A to 6D) of the electronic device, and may form an attaching force by magnetism.

According to an embodiment, in the 1-1th rotation cam member 360a, as the area in which the protruding portions 354a-1 and the protruding portions 354a-1 of the first facing portion 354a overlap in the length direction of the electronic device increases, the attaching force by magnetism may increase. For example, as the protruding portions 354a-1 are disposed closer to the 1-1th magnetic members 363a than the concave portions 354a-2, the magnetic attaching force formed by the tiny area of the protruding portion 354a-1 and the tiny area of the 1-1th magnetic member 363a may be larger than the magnetic attaching force formed by the tiny area of the concave portion 354a-2 and the tiny area of the 1-1th magnetic member 363a.

Referring to FIG. 12B, the 1-1th magnetic members 363a may be disposed at intervals of 30 degrees with respect to the 1-1th rotation axis 361a.

Referring to FIG. 13, when the electronic device is changed from the unfolded state (e.g., the rotation angle of 0 degrees in FIG. 2 or 13) to the folded state (e.g., the rotation angle of 90 degrees in FIG. 3 or 13), a graph of the attaching force formed by the 1-1th magnetic members 363a and the first facing portion 354a is illustrated. The horizontal axis of FIG. 13 represents the rotation angle of the electronic device or the rotation angle of the 1-1th rotation cam member 360a with respect to the first hinge bracket 350a, and the vertical axis of FIG. 13 represents the attaching force F by magnetism formed between the first hinge bracket 350a (e.g., the first facing portion 354a) and the 1-1th rotation cam member 360a (e.g., the 1-1th magnetic member 363a).

Referring to FIG. 13, when the 1-1th rotation cam member 360a is changed from 0 degrees to 30 degrees with respect to the first hinge bracket 350a, the area in which the 1-1th magnetic members 363a and the concave portions 354a-2 overlap each other in the length direction of the electronic device increases and then decreases, and thus the attaching force by magnetism formed by the 1-1th magnetic members 363a and the first facing portion 354a may decrease and then increase.

Further, when the rotation angle is 30 degrees, any one of the 1-1th magnetic members 363a does not overlap the first facing portion 354a in the length direction of the electronic device, and thus it may be identified that the attaching force by magnetism formed when the rotation angle is 30 degrees is lower than the attaching force by magnetism formed when the rotation angle is 0 degrees.

When the 1-1th rotation cam member 360a is changed from 30 degrees to 60 degrees with respect to the first hinge bracket 350a, the area in which the 1-1th magnetic members 363a and the concave portions 354a-2 overlap each other in the length direction of the electronic device increases and then decreases, so that the attaching force by magnetism formed by the 1-1th magnetic members 363a and the first facing portion 354a may decrease and then increase.

Further, when the rotation angle is 60 degrees, two of the 1-1th magnetic members 363a do not overlap the first facing portion 354a in the length direction of the electronic device, and thus it may be identified that the attaching force by magnetism formed when the rotation angle is 60 degrees is lower than the attaching force by magnetism formed when the rotation angle is 30 degrees.

When the 1-1th rotation cam member 360a is changed from 60 degrees to 90 degrees with respect to the first hinge bracket 350a, the area in which the 1-1th magnetic members 363a and the concave portions 354a-2 overlap each other in the length direction of the electronic device increases and then decreases, so that the attaching force by magnetism formed by the 1-1th magnetic members 363a and the first facing portion 354a may decrease and then increase.

Further, when the rotation angle is 90 degrees, three of the 1-1th magnetic members 363a do not overlap the first facing portion 354a in the length direction of the electronic device, and thus it may be identified that the attaching force by magnetism formed when the rotation angle is 90 degrees is lower than the attaching force by magnetism formed when the rotation angle is 60 degrees.

Further, it may be identified that the attaching force by magnetism formed when the rotation angle is 90 degrees is lower than the attaching force by magnetism formed when the rotation angle is 0 degrees (e.g., the difference G between the attaching forces of FIG. 13).

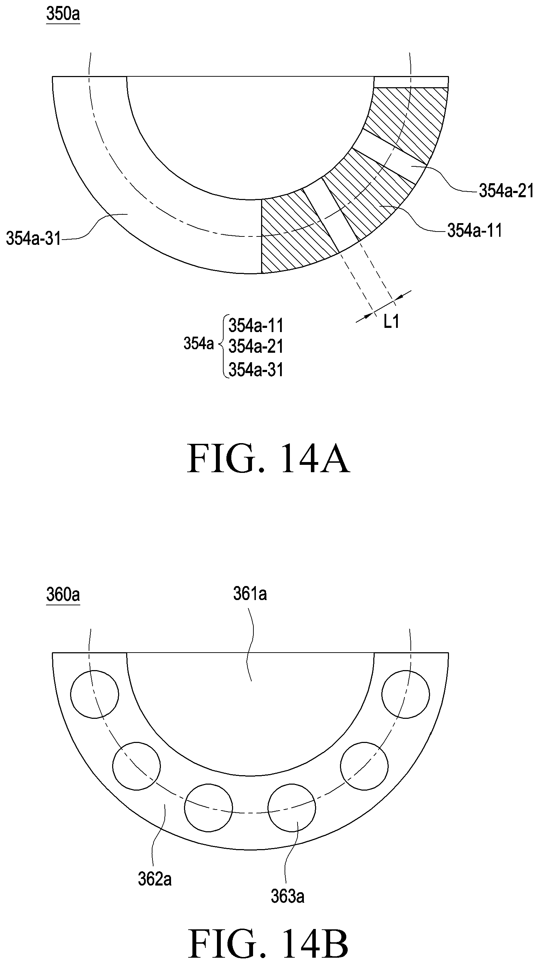

FIG. 14A is a view illustrating a first facing portion of a first hinge bracket according to an embodiment of the disclosure.

FIG. 14B is a view illustrating 1-1th magnetic members of a 1-1th rotation cam member according to an embodiment of the disclosure.

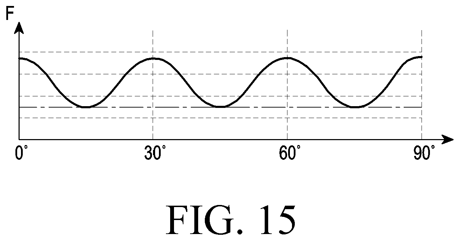

FIG. 15 is a view illustrating an attaching force by magnetism according to an embodiment of the disclosure.

The descriptions of the first hinge bracket and the 1-1th rotation cam member described with reference to FIGS. 14A to 15 may be equally applied to and understood for the first hinge bracket and the 1-2th rotation cam member, the second hinge bracket and the 2-1th rotation cam member, or the second hinge bracket and the 2-2th rotation cam member of FIGS. 6A to 6D.

Referring to FIG. 14A, the first hinge bracket 350a (e.g., the first hinge bracket 350a of FIGS. 6A to 6D) may include the first facing portion 354a (e.g., the first facing portion 354a of FIGS. 6A to 6D). The first facing portion 354a may include protruding portions 354a-11 protruding from the concave portions 354a-21, and concave portions 354a-21 concave from the protruding portions 354a-11. According to an embodiment, the protruding portions 354a-11 and the concave portions 354a-21 may be alternately disposed in half of the first facing portion 354a, and the remaining portion of the first facing portion 354a may further include a recess portion 354a-31 formed to be more concave than the protruding portions 354a-11 in the same or similar manner as the concave portion 354a-21. According to an embodiment, the thicknesses of the concave portions 354a-21 may be a designated first thickness L1.

Referring to FIG. 14B, a 1-1th rotation cam member 360a (e.g., the 1-1th rotation cam member 360a of FIGS. 6A to 6D) may include a 1-1th rotation shaft 361a (e.g., the 1-1th rotation shaft 361a of FIGS. 6A to 6D), a 1-1th insertion recess 362a (e.g., the 1-1th insertion recess 362a of FIGS. 6A to 6D), or a plurality of 1-1th magnetic members 363a (e.g., the 1-1th magnetic members 363a of FIGS. 6A to 6D).

According to an embodiment, the plurality of 1-1th magnetic members 363a may be disposed to overlap the first facing portion 354a in the length direction (e.g., the Y-axis direction of FIGS. 6A to 6D) of the electronic device, and may form an attaching force by magnetism.

According to an embodiment, in the 1-1th rotation cam member 360a, as the area in which the protruding portions 354a-11 and the protruding portions 354a-1 of the first facing portion 354a overlap in the length direction of the electronic device increases, the attaching force by magnetism may increase. For example, as the protruding portions 354a-11 are disposed closer to the 1-1th magnetic members 363a than the concave portions 354a-21, the magnetic attaching force formed by the tiny area of the protruding portion 354a-11 and the tiny area of the 1-1th magnetic member 363a may be larger than the magnetic attaching force formed by the tiny area of the concave portion 354a-21 and the tiny area of the 1-1th magnetic member 363a. According to an embodiment, the magnetic attaching force formed by the tiny area of the protruding portion 354a-11 and the tiny area of the 1-1th magnetic member 363a may be larger than the magnetic attaching force formed by the tiny area of the recess portion 354a-31 and the tiny area of the 1-1th magnetic member 363a.

Referring to FIG. 14B, the 1-1th magnetic members 363a may be disposed at intervals of 30 degrees with respect to the 1-1th rotation axis 361a.

Referring to FIG. 15, when the electronic device is changed from the unfolded state (e.g., the rotation angle of 0 degrees in FIG. 2 or 15) to the folded state (e.g., the rotation angle of 90 degrees in FIG. 3 or 15), a graph of the attaching force formed by the 1-1th magnetic members 363a and the first facing portion 354a is illustrated. The horizontal axis of FIG. 15 represents the rotation angle of the electronic device or the rotation angle of the 1-1th rotation cam member 360a with respect to the first hinge bracket 350a, and the vertical axis of FIG. 15 represents the attaching force F by magnetism formed between the first hinge bracket 350a (e.g., the first facing portion 354a) and the 1-1th rotation cam member 360a (e.g., the 1-1th magnetic member 363a).

Referring to FIG. 15, when the 1-1th rotation cam member 360a is changed from 0 degrees to 30 degrees with respect to the first hinge bracket 350a, the area in which the 1-1th magnetic members 363a and the concave portions 354a-21 overlap each other in the length direction of the electronic device increases and then decreases, and thus the attaching force by magnetism formed by the 1-1th magnetic members 363a and the first facing portion 354a may decrease and then increase.

Further, when the rotation angle is 0 degrees and 30 degrees, all of the 1-1th magnetic members 363a are disposed to overlap the first facing portion 354a in the length direction of the electronic device, and thus it may be identified that the attaching forces by magnetism formed when the rotation angle is 0 degrees and 30 degrees are substantially the same.

When the 1-1th rotation cam member 360a is changed from 30 degrees to 60 degrees with respect to the first hinge bracket 350a, the area in which the 1-1th magnetic members 363a and the concave portions 354a-21 overlap each other in the length direction of the electronic device increases and then decreases, so that the attaching force by magnetism formed by the 1-1th magnetic members 363a and the first facing portion 354a may decrease and then increase.

Further, when the rotation angle is 30 degrees and 60 degrees, all of the 1-1th magnetic members 363a are disposed to overlap the first facing portion 354a in the length direction of the electronic device, and thus it may be identified that the attaching forces by magnetism formed when the rotation angle is 30 degrees and 60 degrees are substantially the same.

When the 1-1th rotation cam member 360a is changed from 60 degrees to 90 degrees with respect to the first hinge bracket 350a, the area in which the 1-1th magnetic members 363a and the concave portions 354a-21 overlap each other in the length direction of the electronic device increases and then decreases, so that the attaching force by magnetism formed by the 1-1th magnetic members 363a and the first facing portion 354a may decrease and then increase.

Further, when the rotation angle is 60 degrees and 90 degrees, all of the 1-1th magnetic members 363a are disposed to overlap the first facing portion 354a in the length direction of the electronic device, and thus it may be identified that the attaching forces by magnetism formed when the rotation angle is 0 degrees and 30 degrees are substantially the same.

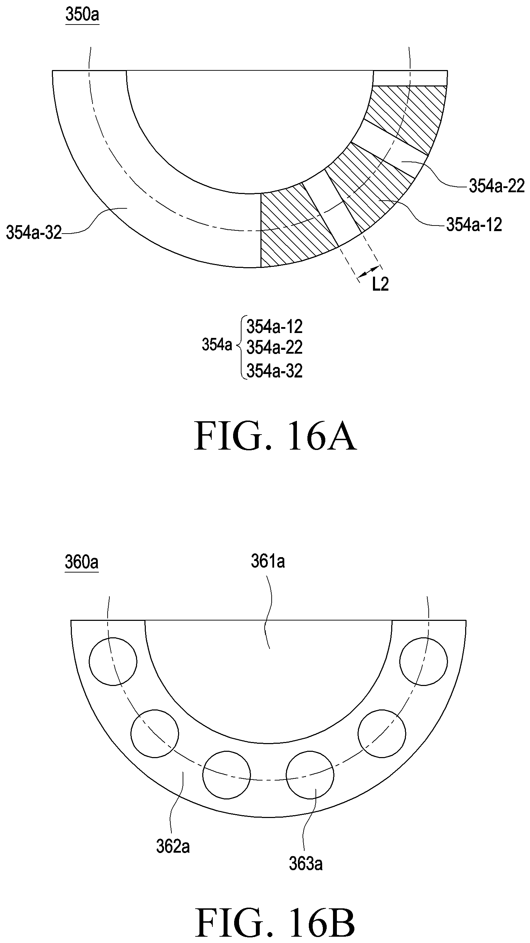

FIG. 16A is a view illustrating a first facing portion of a first hinge bracket according to an embodiment of the disclosure.

FIG. 16B is a view illustrating 1-1th magnetic members of a 1-1th rotation cam member according to an embodiment of the disclosure.

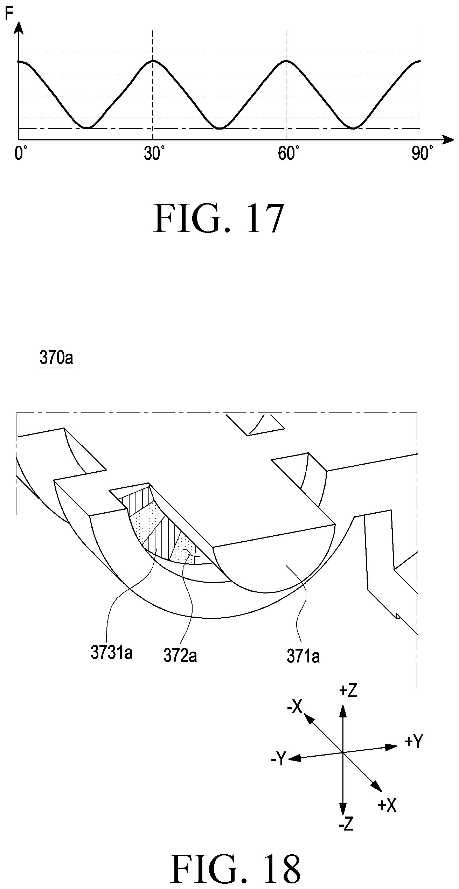

FIG. 17 is a view illustrating an attaching force by magnetism according to an embodiment of the disclosure.

The descriptions of the first hinge bracket and the 1-1th rotation cam member described with reference to FIGS. 16A to 17 may be equally applied to and understood for the first hinge bracket and the 1-2th rotation cam member, the second hinge bracket and the 2-1th rotation cam member, or the second hinge bracket and the 2-2th rotation cam member of FIGS. 6A to 6D.

Referring to FIG. 16A, the first hinge bracket 350a (e.g., the first hinge bracket 350a of FIGS. 6A to 6D) may include the first facing portion 354a (e.g., the first facing portion 354a of FIGS. 6A to 6D). The first facing portion 354a may include protruding portions 354a-12 protruding from the concave portions 354a-22, and concave portions 354a-22 concave from the protruding portions 354a-12. According to an embodiment, the protruding portions 354a-12 and the concave portions 354a-22 may be alternately disposed in half of the first facing portion 354a, and the remaining portion of the first facing portion 354a may further include a recess portion 354a-32 formed to be more concave than the protruding portions 354a-12 in the same or similar manner as the concave portion 354a-22. According to an embodiment, the thicknesses of the concave portions 354a-22 may be a designated second thickness L2. The second thickness L2 may be larger than the first thickness L1, which is the thickness of the concave portions 354a-21 of FIG. 14A.

Referring to FIG. 16B, a 1-1th rotation cam member 360a (e.g., the 1-1th rotation cam member 360a of FIGS. 6A to 6D) may include a 1-1th rotation shaft 361a (e.g., the 1-1th rotation shaft 361a of FIGS. 6A to 6D), a 1-1th insertion recess 362a (e.g., the 1-1th insertion recess 362a of FIGS. 6A to 6D), or a plurality of 1-1th magnetic members 363a (e.g., the 1-1th magnetic members 363a of FIGS. 6A to 6D).

According to an embodiment, the plurality of 1-1th magnetic members 363a may be disposed to overlap the first facing portion 354a in the length direction (e.g., the Y-axis direction of FIGS. 6A to 6D) of the electronic device, and may form an attaching force by magnetism.

According to an embodiment, in the 1-1th rotation cam member 360a, as the area in which the protruding portions 354a-12 and the protruding portions 354a-1 of the first facing portion 354a overlap in the length direction of the electronic device increases, the attaching force by magnetism may increase. For example, as the protruding portions 354a-12 are disposed closer to the 1-1th magnetic members 363a than the concave portions 354a-22, the magnetic attaching force formed by the tiny area of the protruding portion 354a-12 and the tiny area of the 1-1th magnetic member 363a may be larger than the magnetic attaching force formed by the tiny area of the concave portion 354a-22 and the tiny area of the 1-1th magnetic member 363a. According to an embodiment, the magnetic attaching force formed by the tiny area of the protruding portion 354a-12 and the tiny area of the 1-1th magnetic member 363a may be larger than the magnetic attaching force formed by the tiny area of the recess portion 354a-32 and the tiny area of the 1-1th magnetic member 363a.

Referring to FIG. 16B, the 1-1th magnetic members 363a may be disposed at intervals of 30 degrees with respect to the 1-1th rotation axis 361a.

Referring to FIG. 17, when the electronic device is changed from the unfolded state (e.g., the rotation angle of 0 degrees in FIG. 2 or 17) to the folded state (e.g., the rotation angle of 90 degrees in FIG. 3 or 17), a graph of the attaching force formed by the 1-1th magnetic members 363a and the first facing portion 354a is illustrated.

Referring to FIG. 17, when the 1-1th rotation cam member 360a is changed from 0 degrees to 30 degrees with respect to the first hinge bracket 350a, the area in which the 1-1th magnetic members 363a and the concave portions 354a-22 overlap each other in the length direction of the electronic device increases and then decreases, and thus the attaching force by magnetism formed by the 1-1th magnetic members 363a and the first facing portion 354a may decrease and then increase. The horizontal axis of FIG. 17 represents the rotation angle of the electronic device or the rotation angle of the 1-1th rotation cam member 360a with respect to the first hinge bracket 350a, and the vertical axis of FIG. 17 represents the attaching force F by magnetism formed between the first hinge bracket 350a (e.g., the first facing portion 354a) and the 1-1th rotation cam member 360a (e.g., the 1-1th magnetic member 363a).

Further, when the rotation angle is 0 degrees and 30 degrees, all of the 1-1th magnetic members 363a are disposed to overlap the first facing portion 354a in the length direction of the electronic device, and thus it may be identified that the attaching forces by magnetism formed when the rotation angle is 0 degrees and 30 degrees are substantially the same.

When the 1-1th rotation cam member 360a is changed from 30 degrees to 60 degrees with respect to the first hinge bracket 350a, the area in which the 1-1th magnetic members 363a and the concave portions 354a-22 overlap each other in the length direction of the electronic device increases and then decreases, so that the attaching force by magnetism formed by the 1-1th magnetic members 363a and the first facing portion 354a may decrease and then increase.

Further, when the rotation angle is 30 degrees and 60 degrees, all of the 1-1th magnetic members 363a are disposed to overlap the first facing portion 354a in the length direction of the electronic device, and thus it may be identified that the attaching forces by magnetism formed when the rotation angle is 30 degrees and 60 degrees are substantially the same.

When the 1-1th rotation cam member 360a is changed from 60 degrees to 90 degrees with respect to the first hinge bracket 350a, the area in which the 1-1th magnetic members 363a and the concave portions 354a-22 overlap each other in the length direction of the electronic device increases and then decreases, so that the attaching force by magnetism formed by the 1-1th magnetic members 363a and the first facing portion 354a may decrease and then increase.

Further, when the rotation angle is 60 degrees and 90 degrees, all of the 1-1th magnetic members 363a are disposed to overlap the first facing portion 354a in the length direction of the electronic device, and thus it may be identified that the attaching forces by magnetism formed when the rotation angle is 60 degrees and 90 degrees are substantially the same.

Further, since the thickness L2 of the concave portion 354a-22 of FIG. 16A is larger than the thickness L1 of the concave portion 354a-21 of FIG. 14A, it may be identified that the attaching force (e.g., the lowest attaching force formed by the first facing portion 354a of FIG. 16A and the first magnetic members 363a of FIG. 16B) when the area where the concave portion 354a-22 of FIG. 16A overlaps the first magnetic member 363a in the length direction of the electronic device is the largest is lower than the attaching force (e.g., the lowest attaching force formed by the first facing portion 354a of FIG. 14A and the first magnetic members 363a of FIG. 14B) when the area where the concave portion 354a-21 of FIG. 14A overlaps the first magnetic member 363a in the length direction of the electronic device is the largest.

FIG. 18 is a perspective view illustrating a portion of a 2-1th rotation cam member according to an embodiment of the disclosure.

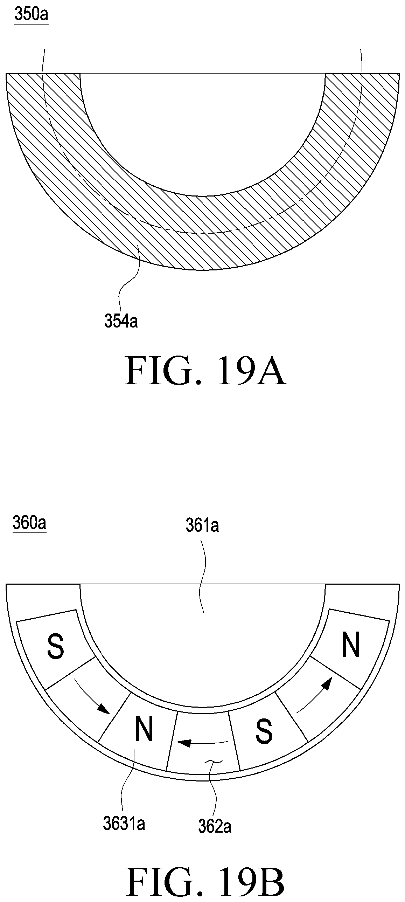

The embodiment of FIG. 18 may be combined with the embodiments of FIGS. 1 to 17, or the embodiments of FIGS. 19A to 22.

The description of the 2-1th rotation cam member and the 2-1th magnetic member 3731a described with reference to the embodiment of FIG. 18 may be equally applied to and understood for the rotation cam members and the magnetic members of FIGS. 6A to 6D.

According to an embodiment, the 2-1th rotation cam member 370a (e.g., the 2-1th rotation cam member 370a of FIGS. 6A to 6D) may include a 2-1th rotation shaft 371a (e.g., the 2-1th rotation shaft 371a of FIGS. 6A to 6D), a 2-1th insertion recess 372a (e.g., the 2-1th insertion recess 372a of FIGS. 6A to 6D), or 2-1th magnetic members 3731a (e.g., the plurality of 2-1th magnetic members 373a of FIGS. 6A to 6D).

According to an embodiment, the 2-1th magnetic members 3731a may be permanent magnets arranged in a Halbach array.

According to an embodiment, the 2-1th magnetic members 3731a may be arranged in a Halbach array so that the magnetic field formed by the 2-1th magnetic members 3731a may be concentrated in the second facing portion (e.g., the second facing portion 354b of FIGS. 6A to 6D) inserted into the 2-1th insertion recess 372a.

FIG. 19A is a view illustrating a first facing portion of a first hinge bracket according to an embodiment of the disclosure.

FIG. 19B is a view illustrating 1-1th magnetic members of a 1-1th rotation cam member, arranged in a Halbach array, according to an embodiment of the disclosure.

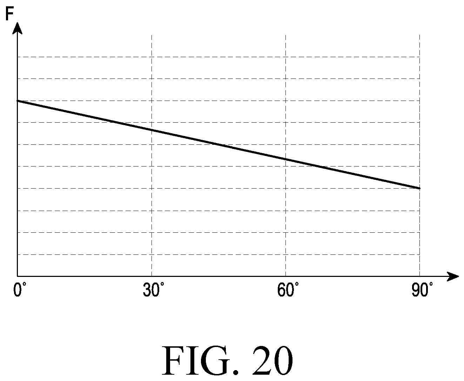

FIG. 20 is a view illustrating an attaching force by magnetism according to an embodiment of the disclosure.

The descriptions of the first hinge bracket and the 1-1th rotation cam member described with reference to FIGS. 19A to 20 may be equally applied to and understood for the first hinge bracket and the 1-2th rotation cam member, the second hinge bracket and the 2-1th rotation cam member, or the second hinge bracket and the 2-2th rotation cam member of FIGS. 6A to 6D.

Referring to FIG. 19A, the first hinge bracket 350a (e.g., the first hinge bracket 350a of FIGS. 6A to 6D) may include the first facing portion 354a (e.g., the first facing portion 354a of FIGS. 6A to 6D). The first facing portion 354a of FIG. 19A may be formed as a flat area without a portion protruding or concave compared to other portions.

Referring to FIG. 19B, a 1-1th rotation cam member 360a (e.g., the 1-1th rotation cam member 360a of FIGS. 6A to 6D) may include a 1-1th rotation shaft 361a (e.g., the 1-1th rotation shaft 361a of FIGS. 6A to 6D), a 1-1th insertion recess 362a (e.g., the 1-1th insertion recess 362a of FIGS. 6A to 6D), or a plurality of 1-1th magnetic members 3631a (e.g., the 1-1th magnetic members 363a of FIGS. 6A to 6D) arranged in a Halbach array.

According to an embodiment, the plurality of 1-1th magnetic members 3631a may be disposed to overlap the first facing portion 354a in the length direction (e.g., the Y-axis direction of FIGS. 6A to 6D) of the electronic device, and may form an attaching force by magnetism.

Referring to FIG. 20, when the electronic device is changed from the unfolded state (e.g., the rotation angle of 0 degrees in FIG. 2 or 20) to the folded state (e.g., the rotation angle of 90 degrees in FIG. 3 or 20), a graph of the attaching force formed by the 1-1th magnetic members 3631a and the first facing portion 354a is illustrated. The horizontal axis of FIG. 20 represents the rotation angle of the electronic device or the rotation angle of the 1-1th rotation cam member 360a with respect to the first hinge bracket 350a, and the vertical axis of FIG. 20 represents the attaching force F by magnetism formed between the first hinge bracket 350a (e.g., the first facing portion 354a) and the 1-1th rotation cam member 360a (e.g., the 1-1th magnetic member 3631a).

Referring to FIG. 20, when the 1-1th rotation cam member 360a is changed from 0 degrees to 90 degrees with respect to the first hinge bracket 350a, the area in which the 1-1th magnetic members 3631a and the first facing portion 354a overlap each other in the length direction of the electronic device gradually decreases, and thus the attaching force by magnetism formed by the 1-1th magnetic members 3631a and the first facing portion 354a may decrease with a constant slope.

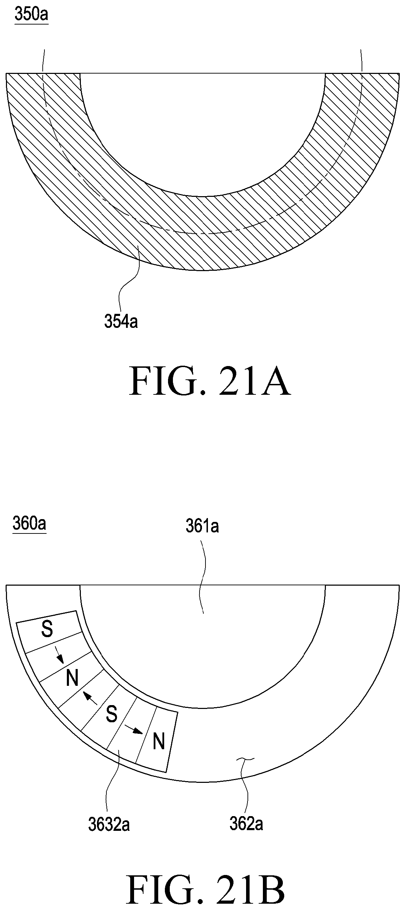

FIG. 21A is a view illustrating a first facing portion of a first hinge bracket according to an embodiment of the disclosure.

FIG. 21B is a view illustrating 1-1th magnetic members of a 1-1th rotation cam member, arranged in a Halbach array, according to an embodiment of the disclosure.

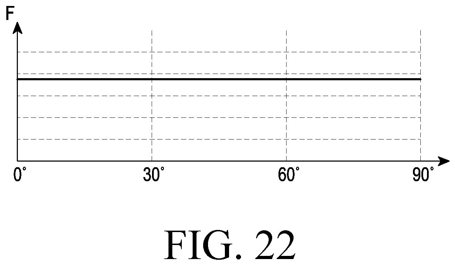

FIG. 22 is a view illustrating an attaching force by magnetism according to an embodiment of the disclosure.

The descriptions of the first hinge bracket and the 1-1th rotation cam member described with reference to FIGS. 21A to 22 may be equally applied to and understood for the first hinge bracket and the 1-2th rotation cam member, the second hinge bracket and the 2-1th rotation cam member, or the second hinge bracket and the 2-2th rotation cam member of FIGS. 6A to 6D.

Referring to FIG. 21A, the first hinge bracket 350a (e.g., the first hinge bracket 350a of FIGS. 6A to 6D) may include the first facing portion 354a (e.g., the first facing portion 354a of FIGS. 6A to 6D). The first facing portion 354a of FIG. 21A may be formed as a flat area without a portion protruding or concave compared to other portions.

Referring to FIG. 21B, a 1-1th rotation cam member 360a (e.g., the 1-1th rotation cam member 360a of FIGS. 6A to 6D) may include a 1-1th rotation shaft 361a (e.g., the 1-1th rotation shaft 361a of FIGS. 6A to 6D), a 1-1th insertion recess 362a (e.g., the 1-1th insertion recess 362a of FIGS. 6A to 6D), or a plurality of 1-1th magnetic members 3632a (e.g., the 1-1th magnetic members 363a of FIGS. 6A to 6D) arranged in a Halbach array. According to an embodiment, the plurality of 1-1th magnetic members 3632a may be disposed in half of the 1-1th insertion recess 362a but may not be disposed in the rest of the 1-1th insertion recess 362a.

According to an embodiment, the plurality of 1-1th magnetic members 3632a may be disposed to overlap the first facing portion 354a in the length direction (e.g., the Y-axis direction of FIGS. 6A to 6D) of the electronic device, and may form an attaching force by magnetism.

Referring to FIG. 22, when the electronic device is changed from the unfolded state (e.g., the rotation angle of 0 degrees in FIG. 2 or 22) to the folded state (e.g., the rotation angle of 90 degrees in FIG. 3 or 22), a graph of the attaching force formed by the 1-1th magnetic members 3632a and the first facing portion 354a is illustrated. The horizontal axis of FIG. 22 represents the rotation angle of the electronic device or the rotation angle of the 1-1th rotation cam member 360a with respect to the first hinge bracket 350a, and the vertical axis of FIG. 22 represents the attaching force F by magnetism formed between the first hinge bracket 350a (e.g., the first facing portion 354a) and the 1-1th rotation cam member 360a (e.g., the 1-1th magnetic member 3632a).

Referring to FIG. 22, when the 1-1th rotation cam member 360a is changed from 0 degrees to 90 degrees with respect to the first hinge bracket 350a, the area in which the 1-1th magnetic members 3632a and the first facing portion 354a overlap each other in the length direction of the electronic device is substantially the same, and thus the attaching force by magnetism formed by the 1-1th magnetic members 3632a and the first facing portion 354a may be formed constant.

In the foldable electronic device, the plurality of housings may be connected to be rotatable with respect to each other through the hinge structure. The foldable electronic device may provide a free-stop function to, when the plurality of housings are disposed at a specific angle with respect to each other, maintain the state of being disposed at the specific angle.

In general, the free-stop function of the foldable electronic device may be provided to form a physical frictional force in a state in which a plurality of members included in the hinge structure contact each other and to maintain the state in which the foldable electronic device is disposed at the specific angle through the physical frictional force.

However, when the foldable electronic device is repeatedly rotated (or folded or unfolded), a frictional force is formed in a state in which the plurality of members contact each other. Therefore, the plurality of members may be worn out by repeated use, and thus the pre-stop function may not be properly implemented.

According to an embodiment of the disclosure, there may be provided a hinge structure implementing a free-stop function through an attaching force by magnetism and an electronic device including the same.

The disclosure is not limited to the foregoing embodiments but various modifications or changes may rather be made thereto without departing from the spirit and scope of the disclosure.

The hinge structure and electronic device including the same, according to an embodiment of the disclosure, may implement a free-stop function with an attaching force by magnetism and may thus be prevented from deterioration of the free-stop function despite repeated use.

Effects obtainable from the disclosure are not limited to the above-mentioned effects, and other effects not mentioned may be apparent to one of ordinary skill in the art from the following description.

According to an embodiment of the disclosure, an electronic device 101 may comprise a first housing 210, a second housing 220, at least one hinge structure 231 and 300, or a flexible display 250. The second housing may be configured to be rotated relative to the first housing. The at least one hinge structure may be disposed between the first housing and the second housing. The at least one hinge structure may rotatably connect the first housing and the second housing. The flexible display may be disposed between the first housing and the second housing. The at least one hinge structure may include a first rotation cam member 360a, a second rotation cam member 360b, or at least one hinge bracket 350a. The first rotation cam member may be coupled to the first housing. The first rotation cam member may include a first rotation shaft 361a and a plurality of first magnetic members 363a. The plurality of first magnetic members may be disposed adjacent to the first rotation shaft. The second rotation cam member may be coupled to the second housing. The second rotation cam member may include a second rotation shaft 361b and a plurality of second magnetic members 363b. The plurality of second magnetic members may be disposed adjacent to the second rotation shaft. The at least one hinge bracket may rotatably support the first rotation shaft and the second rotation shaft. The at least one hinge bracket may include at least one facing portion 354a facing the plurality of first magnetic members or the plurality of second magnetic members.

According to an embodiment, the at least one hinge bracket may further include at least one first guide portion 351a rotatably supporting the first rotation shaft and the second rotation shaft.

According to an embodiment, the first rotation cam member may include a first insertion recess 362a formed to surround the first rotation shaft and where the plurality of first magnetic members are disposed. The second rotation cam member may include a second insertion recess 362b formed to surround the second rotation shaft and where the plurality of second magnetic members are disposed.

According to an embodiment, at least a portion of the at least one facing portion may be inserted into the first insertion recess. The rest of the at least one facing portion may be inserted into the second insertion recess.

According to an embodiment, the plurality of first magnetic members or the plurality of second magnetic members may be neodymium magnets.

According to an embodiment, the plurality of first magnetic members or the plurality of second magnetic members may be permanent magnets arranged in a Halbach array.

According to an embodiment, the at least one facing portion may include a plurality of protruding portions 354a-1 and a plurality of concave portions 354a-2. The plurality of protruding portions may be disposed further adjacent to the plurality of first magnetic members or the plurality of second magnetic members than the plurality of concave portions. The plurality of protruding portions may be disposed alternately with the plurality of concave portions.

According to an embodiment, the plurality of first magnetic members may be arranged at equal intervals along an arc shape. The plurality of second magnetic members may be arranged at equal intervals along an arc shape.

According to an embodiment, the at least one hinge structure may further include a hinge plate 310 configured to slidably support the hinge bracket.

According to an embodiment, the at least one hinge structure may further include a first elastic member 391 disposed between at least a portion of the hinge plate and the hinge bracket. The first elastic member may further include a first elastic member configured to pressurize the hinge bracket toward the first rotation cam member and the second rotation cam member.

According to an embodiment, the at least one hinge structure may further include a slide cam member 380 coupled to the hinge plate.

According to an embodiment, the slide cam member may include a 2-1th guide portion 382a configured to rotatably support the first rotation cam member. The slide cam member may include a 2-2th guide portion 382b configured to rotatably support the second rotation cam member.

According to an embodiment, the first rotation cam member may include a first slit portion 367a formed such that the 2-1th guide portion is inserted therein. The second rotation cam member may include a second slit portion 367b formed such that the 2-2th guide portion is inserted therein.

According to an embodiment, the at least one hinge structure may further include a second elastic member 392 configured to pressurize the first rotation cam member or the second rotation cam member toward the hinge bracket.

According to an embodiment, the at least one hinge structure may further include a first guide bracket 330a coupled to the first rotation cam member and the first housing. The hinge structure may further include a second guide bracket 330b coupled to the second rotation cam member and the second housing.

According to an embodiment of the disclosure, an electronic device may comprise a first housing 210, a second housing 220, at least one hinge structure 231 and 300, or a flexible display 250. The second housing may be configured to be rotated relative to the first housing. The at least one hinge structure may be disposed between the first housing and the second housing. The at least one hinge structure may rotatably connect the first housing and the second housing. The flexible display may be disposed between the first housing and the second housing. The at least one hinge structure may include a hinge plate 310, a 1-1th rotation cam member 360a, a 1-2th rotation cam member 360b, or a first hinge bracket 350a. The 1-1th rotation cam member may be coupled to the first housing. The 1-1th rotation cam member may include a 1-1th rotation shaft 361a and a plurality of 1-1th magnetic members 363a. The plurality of 1-1th magnetic members may be disposed adjacent to the 1-1th rotation shaft. The 1-2th rotation cam member may be coupled to the second housing. The 1-2th rotation cam member may include a 1-2th rotation shaft 361b and a plurality of 1-2th magnetic members 363b. The plurality of 1-2th magnetic members may be disposed adjacent to the 1-2th rotation shaft. The first hinge bracket may be slidably coupled to the hinge plate. The first hinge bracket may include at least one first guide portion 351a or at least one first facing portion 354a. The at least one first guide portion may rotatably support the 1-1th rotation shaft and the 1-2th rotation shaft. The at least one first facing portion may face the plurality of 1-1th magnetic members and the plurality of 1-2th magnetic members.

According to an embodiment, the at least one hinge structure may include a 2-1th rotation cam member 370a, a 2-2th rotation cam member 370b, or a second hinge bracket 350b. The 2-1th rotation cam member may be coupled to the first housing. The 2-1th rotation cam member may include a 2-1th rotation shaft 371a or a plurality of 2-1th magnetic members 373a. The plurality of 2-1th magnetic members may be disposed adjacent to the 2-1th rotation shaft. The 2-2th rotation cam member may be coupled to the second housing. The 2-2th rotation cam member may include a 2-2th rotation shaft 371b or a plurality of 2-2th magnetic members 373b. The plurality of 2-2th magnetic members may be disposed adjacent to the 2-2th rotation shaft. The second hinge bracket may be slidably coupled to the hinge plate. The second hinge bracket may include at least one second guide portion 351b rotatably supporting the 2-1th rotation shaft and the 2-2th rotation shaft. The second hinge bracket may include at least one second facing portion 354b facing the plurality of 2-1th magnetic members or the plurality of 2-2th magnetic members.

According to an embodiment, the at least one hinge structure may further include at least one first elastic member 391 configured to pressurize the first hinge bracket toward the 1-1th rotation cam member and the 1-2th rotation cam member. The at least one hinge structure may further include at least one second elastic member 392 configured to pressurize the second hinge bracket toward the 2-1th rotation cam member and the 2-2th rotation cam member.

According to an embodiment, the at least one hinge structure may further include at least one third elastic member 393 disposed in at least one of a space between the 1-1th rotation cam member and the 2-1th rotation cam member or a space between the 1-2th rotation cam member and the 2-2th rotation cam member.

According to an embodiment, the at least one hinge structure may further include a slide cam member coupled to the hinge plate. The slide cam member may further include a slide cam member rotatably supporting at least one of the 1-1th rotation cam member, the 1-2th rotation cam member, the 2-1th rotation cam member, or the 2-2th rotation cam member.

While the disclosure has been shown and described with reference to exemplary embodiments thereof, it will be apparent to those of ordinary skill in the art that various changes in form and detail may be made thereto without departing from the spirit and scope of the disclosure as defined by the following claims.

## Claims

1. An electronic device, comprising:
a first housing (210);
a second housing (220) configured to be rotated relative to the first housing;
at least one hinge structure (231, 300) disposed between the first housing and the second housing and rotatably connecting the first housing and the second housing; and
a flexible display (250) disposed on the first housing and the second housing,
wherein the at least one hinge structure includes:
a first rotation cam member (360a) coupled to the first housing and including a first rotation shaft (361a) and a plurality of first magnetic members (363a) disposed adjacent to the first rotation shaft;
a second rotation cam member (360b) coupled to the second housing and including a second rotation shaft (361b) and a plurality of second magnetic members (363b) disposed adjacent to the second rotation shaft; and
at least one hinge bracket (350a) rotatably supporting the first rotation shaft and the second rotation shaft and including at least one facing portion (354a) facing the plurality of first magnetic members and the plurality of second magnetic members.

2. The electronic device of claim 1, wherein the at least one hinge bracket further includes at least one first guide portion (351a) rotatably supporting the first rotation shaft and the second rotation shaft.

3. The electronic device of any one of claims 1 to 2, wherein the first rotation cam member includes a first insertion recess (362a) formed to surround the first rotation shaft and where the plurality of first magnetic members are disposed, and
wherein the second rotation cam member includes a second insertion recess (362b) formed to surround the second rotation shaft and where the plurality of second magnetic members are disposed.

4. The electronic device of any one of claims 1 to 3, wherein at least a portion of the at least one facing portion is inserted into the first insertion recess, and a rest of the at least one facing portion is inserted into the second insertion recess.

5. The electronic device of any one of claims 1 to 4, wherein the plurality of first magnetic members or the plurality of second magnetic members are neodymium magnets.

6. The electronic device of any one of claims 1 to 5, wherein the plurality of first magnetic members or the plurality of second magnetic members are permanent magnets arranged in a Halbach array.

7. The electronic device of any one of claims 1 to 6, wherein the at least one facing portion includes a plurality of protruding portions (354a-1) and a plurality of concave portions (354a-2), and
wherein the plurality of protruding portions are disposed further adjacent to the plurality of first magnetic members or the plurality of second magnetic members than the plurality of concave portions, and are disposed alternately with the plurality of concave portions.

8. The electronic device of any one of claims 1 to 7, wherein the plurality of first magnetic members are arranged at equal intervals along an arc shape, and the plurality of second magnetic members are arranged at equal intervals along an arc shape.

9. The electronic device of any one of claims 1 to 8, wherein the at least one hinge structure further includes a hinge plate (310) configured to slidably support the hinge bracket.

10. The electronic device of any one of claims 1 to 9, wherein the at least one hinge structure further includes a first elastic member (391) disposed between at least a portion of the hinge plate and the hinge bracket, and configured to pressurize the hinge bracket toward the first rotation cam member and the second rotation cam member.

11. The electronic device of any one of claims 1 to 10, wherein the at least one hinge structure further includes a slide cam member (380) coupled to the hinge plate.

12. The electronic device of any one of claims 1 to 11, wherein the slide cam member includes:
a 2-1th guide portion (382a) configured to rotatably support the first rotation cam member; and
a 2-2th guide portion (382b) configured to rotatably support the second rotation cam member.

13. The electronic device of any one of claims 1 to 12, wherein the first rotation cam member includes a first slit portion (367a) formed such that the 2-1th guide portion is inserted therein, and
wherein the second rotation cam member includes a second slit portion (367b) formed such that the 2-2th guide portion is inserted therein.

14. The electronic device of any one of claims 1 to 13, wherein the at least one hinge structure further includes a second elastic member (392) configured to pressurize the first rotation cam member or the second rotation cam member toward the hinge bracket.

15. The electronic device of any one of claims 1 to 14, wherein the at least one hinge structure includes:
a first guide bracket (330a) coupled to the first rotation cam member and the first housing; and
a second guide bracket (330b) coupled to the second rotation cam member and the second housing.
